# EUROPEAN PATENT APPLICATION

(11) **EP 4 507 010 A1**
(43) Date of publication of application: **12.02.2025**
(21) Application number: 23784530.0
(22) Date of filing: 13.02.2023
(51) Int. Cl.: H01L 31/02, H01L 21/56, H01L 23/28, H01L 27/146

(54) **PACKAGE AND METHOD FOR MANUFACTURING PACKAGE**

(30) Priority: 08.04.2022 JP 2022064203
(71) Applicant: Sony Semiconductor Solutions Corporation, Atsugi-shi, Kanagawa 243-0014 (JP)
(72) Inventor: SHIGETOSHI, Takushi, Atsugi-shi, Kanagawa 243-0014 (JP); SHIMIZU, Kan, Atsugi-shi, Kanagawa 243-0014 (JP); MATSUGAI, Hiroyasu, Atsugi-shi, Kanagawa 243-0014 (JP); YOSHIOKA, Hirotaka, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/004705
(87) International publication number: WO 2023/195236

(57) **Abstract**

It is possible to cope with expansion of functions while suppressing an increase in size of a package.

The package (160) includes a plurality of chips (111, 121), a wiring layer (132), and a molding material (151). The plurality of chips (111, 121) includes an optical chip (111). The plurality of chips (111, 121) is mounted on the wiring layer (132). The molding material (151) is disposed so as to surround the periphery of at least one chip of the plurality of chips (111, 121), and the surface is flattened. The position of the flat surface of the molding material (151) in the height direction may be substantially equal to the position of the top surface of at least one of the plurality of chips (111, 121) in the height direction. The optical chip (111) may include at least one of a light receiving element and a light emitting element.

## Description

### TECHNICAL FIELD

The present technology relates to a package and a method for manufacturing the package. Specifically, the present technology relates to a package on which a chip is mounted and a method for manufacturing the package.

### BACKGROUND ART

In packaging of a semiconductor chip, a three-dimensional integrated structure in which solidified semiconductor chips are stacked may be used in order to suppress an increase in a mounting area. As such a three-dimensional integrated structure, for example, there is a structure in which a first chip and a second chip are mounted on an interposer substrate, and a third chip is stacked on the second chip (see, for example, Patent Document 1).

### CITATION LIST

### PATENT DOCUMENT

Patent Document 1: U.S. Patent Application Publication No. 2019/237454

### SUMMARY OF THE INVENTION

### PROBLEMS TO BE SOLVED BY THE INVENTION

However, in the above-described conventional technique, when the third chip is connected to the interposer substrate or an optical function is incorporated in the package, it is necessary to enlarge the interposer substrate by that amount, which may lead to an increase in size of the package.

The present technology has been made in view of such a situation, and it is an object of the present technology to be able to cope with expansion of functions while suppressing an increase in size of a package.

### SOLUTIONS TO PROBLEMS

The present technology has been made to solve the above-described problems, and a first aspect of the present technology is a package including: a plurality of chips including an optical chip; a wiring layer on which the plurality of chips is mounted; and a molding material disposed so as to surround a periphery of at least one chip of the plurality of chips, the molding material having a flattened surface. This brings about an effect that the optical chip in which the transparent member is provided on an upper side is sealed with the molding material.

Further, according to the first aspect, the position of the flat surface of the molding material in the height direction may be substantially equal to the position of the top surface of at least one of the plurality of chips in the height direction. This brings about an effect that the surface of the transparent member is exposed from the molding material.

Further, according to the first aspect, the optical chip may include at least one of a light receiving element and a light emitting element. This brings about an effect that the optical chip functions as a light receiving element or a light emitting element.

Further, according to the first aspect, the wiring layer on which the plurality of chips is mounted may be a wiring layer formed on an interposer substrate or a rewiring layer formed on the chip. This brings about an effect that the optical chip is supported on the wiring layer.

In addition, the first aspect may further include an antireflection film formed on at least one of a chip other than the optical chip and the molding material. This brings about an effect that the influence of the reflected light from the periphery of the optical chip is avoided.

In addition, the first aspect may further include: a lower layer chip on which at least one of the plurality of chips is mounted; and a through electrode formed in the lower layer chip. This brings about an effect that the mounting area of the chip is reduced.

In addition, the first aspect may further include a dummy chip that is disposed to be separated from a periphery of any one of the plurality of chips in a state where the periphery is surrounded by the molding material, and has a top surface located at substantially the same height as the flat surface of the molding material. This brings about an effect that the uniformity of the height of the mounting region where the chips having different sizes are mounted is improved.

In addition, the first aspect may further include a transparent member provided on an upper side of the optical chip, in which the molding material is positioned so as to surround a periphery of the optical chip in a state where a surface of the transparent member is exposed. This brings about an effect that the optical chip in which the transparent member is provided on an upper side is sealed with the molding material.

Further, according to the first aspect, the transparent member may include at least one of a transparent resin and a transparent substrate. This brings about an effect that the periphery of the optical chip is sealed with the molding material while the upper side of the optical chip is sealed with the transparent member.

Further, according to the first aspect, the transparent member may include an optical functional layer. This brings about an effect that an optical function is added while the periphery of the optical chip is sealed with the molding material.

Further, according to the first aspect, a top surface of the optical chip may be at a position lower than a top surface of the molding material. This brings about an effect that the periphery of the optical chip is protected by the molding material.

In addition, the first aspect may further include a transparent substrate or an optical member disposed on an upper side of the optical chip and supported by the dummy chip. This brings about an effect that sealing of the optical chip or addition of an optical function is achieved without providing a support member of the transparent substrate or the optical member separately from the dummy chip.

Further, according to the first aspect, a top surface of the optical chip may be at a position higher than a top surface of the molding material. This brings about an effect that the influence of the molding material on the optical characteristics of the optical chip is avoided.

Furthermore, the first aspect may further include an underfill provided between at least one of the plurality of chips and the wiring layer and around the chip. This brings about an effect that the sealing property of the chip is improved.

In addition, according to the first aspect, in which at least a part including an upper end of one surface facing the chip among surfaces of the dummy chip may have a larger interval from a chip surrounded by the dummy chip than other surfaces facing the chip. This brings about an effect that the inflow path of the underfill between the dummy chip and the chip is enlarged.

In addition, according to the first aspect, at least one surface facing the chip among surfaces of the dummy chip may have a forward tapered shape. This brings about an effect that inflow of the underfill between the dummy chip and the chip is facilitated.

In addition, a second aspect is a package including: an optical chip mounted on a substrate; a transparent member provided on the optical chip; and a sealing resin whose surface is flattened so that a surface of the transparent member is exposed and which is formed on the substrate so as to surround a periphery of the optical chip. This brings about an effect that the optical chip in which the transparent member is provided on the upper side is sealed with the sealing resin.

In addition, according to the second aspect, the flattened surface is a polished surface on which polishing is stopped at a position of the transparent member. This brings about an effect that the optical function of the optical chip is secured while the optical chip on which the transparent member is provided on the upper side is sealed with the sealing resin.

Further, a third aspect is a package including: a first chip on which a first wiring layer is formed; an extended rewiring layer electrically connected to the first wiring layer and extended in a lateral direction from a mounting region of the first chip; and a second chip which is mounted on the extended rewiring layer while being separated from the first chip and on which a second wiring layer electrically connected to the extended rewiring layer is formed. This brings about an effect that the second chip is mounted on the extended rewiring layer electrically connected to the first wiring layer of the first chip.

In addition, the third aspect may further include a molding material formed on the extended rewiring layer so as to surround a periphery of at least one chip of the first chip and the second chip, the molding material having a flattened surface. This brings about an effect that the chip on the extended rewiring layer on which the plurality of chips is mounted is sealed.

In addition, the third aspect may further include a dummy chip that is disposed on the extended rewiring layer while being separated from a periphery of at least one chip of the first chip and the second chip in a state where a periphery is surrounded by the molding material, and has a top surface located at substantially the same height as a surface of the molding material. This brings about an effect that the uniformity of the height of the mounting region on the extended rewiring layer on which the plurality of chips having different sizes is mounted is improved.

Further, a fourth aspect is a package including: an optical chip mounted on a substrate; a dummy chip that is disposed on the substrate while being separated from a periphery of the optical chip and protrudes from a top surface of the optical chip; and a transparent member disposed on an upper side of the optical chip and supported by the dummy chip. This brings about an effect that the optical chip is sealed without providing the support member of the transparent substrate separately from the dummy chip.

In addition, the fourth aspect may further include a molding material formed on the substrate so as to surround a periphery of the dummy chip and having a flattened surface. This brings about an effect that the periphery of the optical chip is sealed while the upper side of the optical chip is sealed with the transparent substrate.

In addition, a fifth aspect is a method for manufacturing a package, the method including: a step of sealing an optical chip provided with a transparent member on an upper side together with a dummy substrate with a molding material; a step of flattening a surface of the molding material to expose surfaces of the transparent member and the dummy substrate; a step of removing at least a part of the dummy substrate whose surface is exposed; and a step of mounting a chip in a region from which the dummy substrate has been removed. This brings about an effect that while the upper side of the optical chip is sealed with the transparent member, the periphery of the optical chip is sealed with the molding material, and the chip is retrofitted to a position surrounded by the dummy substrate.

In addition, in the fifth aspect, flattening of the surface of the molding material may be stopped at a position of the transparent member. This brings about an effect that the optical function of the optical chip is secured while the optical chip on which the transparent member is provided on the upper side is sealed with the molding material.

In addition, a sixth aspect is a method for manufacturing a package, the method including: a step of sealing a chip and a dummy substrate with a molding material; a step of flattening a surface of the molding material to expose a surface of the dummy substrate; a step of removing at least a part of the dummy substrate whose surface is exposed; and a step of mounting an optical chip on a region from which the dummy substrate has been removed. This brings about an effect that the optical chip is retrofitted to a position surrounded by the dummy substrate while the periphery of the chip is sealed with the molding material.

### BRIEF DESCRIPTION OF DRAWINGS

Fig. 1 is a diagram illustrating a configuration example of a package according to a first embodiment.
Fig. 2 is a cross-sectional view illustrating a configuration example of a package according to a second embodiment.
Fig. 3 is a plan view illustrating a configuration example of the package according to the second embodiment.
Fig. 4 is a first cross-sectional view and a plan view illustrating an example of a method for manufacturing a package according to the second embodiment.
Fig. 5 is a second cross-sectional view illustrating an example of the method for manufacturing a package according to the second embodiment.
Fig. 6 is a third cross-sectional view illustrating an example of the method for manufacturing a package according to the second embodiment.
Fig. 7 is a fourth cross-sectional view illustrating an example of the method for manufacturing a package according to the second embodiment.
Fig. 8 is a fifth cross-sectional view illustrating an example of the method for manufacturing a package according to the second embodiment.
Fig. 9 is a sixth cross-sectional view illustrating an example of the method for manufacturing a package according to the second embodiment.
Fig. 10 is a seventh cross-sectional view illustrating an example of the method for manufacturing a package according to the second embodiment.
Fig. 11 is an eighth cross-sectional view illustrating an example of the method for manufacturing a package according to the second embodiment.
Fig. 12 is a ninth cross-sectional view illustrating an example of the method for manufacturing a package according to the second embodiment.
Fig. 13 is a tenth cross-sectional view illustrating an example of the method for manufacturing a package according to the second embodiment.
Fig. 14 is an eleventh cross-sectional view illustrating an example of the method for manufacturing a package according to the second embodiment.
Fig. 15 is a cross-sectional view illustrating a configuration example of a package according to a third embodiment.
Fig. 16 is a cross-sectional view illustrating a modification of a configuration of the package according to the third embodiment.
Fig. 17 is a first cross-sectional view illustrating an example of the method for manufacturing a package according to the third embodiment.
Fig. 18 is a second cross-sectional view illustrating an example of the method for manufacturing a package according to the third embodiment.
Fig. 19 is a cross-sectional view illustrating a configuration example of a package according to a fourth embodiment.
Fig. 20 is a cross-sectional view illustrating a configuration example of a package according to a fifth embodiment.
Fig. 21 is a diagram illustrating a configuration example of a package according to a sixth embodiment.
Fig. 22 is a cross-sectional view illustrating a configuration example of a package according to a seventh embodiment.
Fig. 23 is a cross-sectional view illustrating a configuration example of a package according to an eightieth embodiment.
Fig. 24 is a plan view illustrating a configuration example of a dummy chip of a package according to the eighth embodiment.
Fig. 25 is a cross-sectional view illustrating a configuration example of a package according to a ninth embodiment.
Fig. 26 is a cross-sectional view illustrating a configuration example of a package according to a tenth embodiment.
Fig. 27 is a block diagram illustrating a schematic configuration example of a vehicle control system.
Fig. 28 is an explanatory diagram illustrating an example of an installation position of an imaging section.

### MODE FOR CARRYING OUT THE INVENTION

Modes for carrying out the present technology (hereinafter, referred to as embodiments) will be described below. The description will be given in the following order.
1. First embodiment (example in which optical chip in which transparent member is disposed on upper side so as to surround periphery with molding material having flattened surface is mounted on interposer substrate)
2. Second embodiment (example in which semiconductor chip is retrofitted onto interposer substrate on which optical chip in which transparent member is disposed on upper side is mounted so as to surround periphery with molding material having flattened surface)
3. Third Embodiment (example of providing an optical functional layer on a transparent member disposed on an upper side of an optical chip)
4. Fourth Embodiment (example in which semiconductor chip is retrofitted onto extended rewiring layer on which optical chip in which transparent member supported by molding material is disposed on upper side is mounted)
5. Fifth Embodiment (example of providing antireflection film on molding material and dummy chip)
6. Sixth embodiment (example in which transparent member located on upper side of optical chip is supported by dummy chip)
7. Seventh embodiment (example in which transparent substrate located on upper side of optical chip retrofitted to interposer substrate on which semiconductor chip surrounded by molding material with flattened surface is mounted is supported by dummy chip)
8. Eighth Embodiment (example of widening gap between optical chip into which underfill is injected and dummy chip)
9. Ninth embodiment (example in which inner surface of dummy chip has forward tapered shape)
10. Tenth embodiment (example of providing lower layer chip on which optical chip is mounted)
11. Example of application to mobile object

### <1. First embodiment>

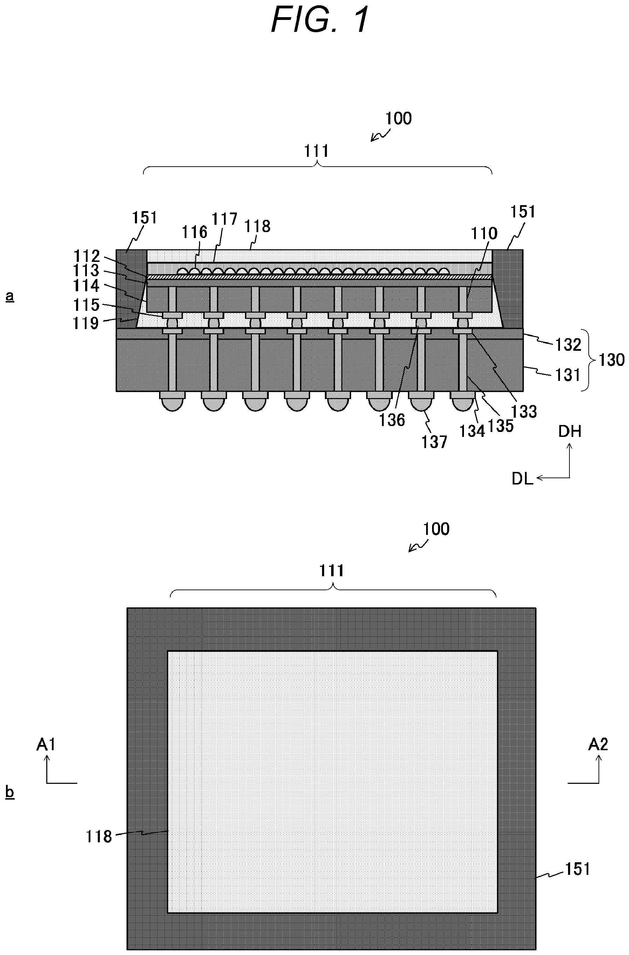

Fig. 1 is a diagram illustrating a configuration example of a package according to a first embodiment. Note that a in the drawing is a cross-sectional view illustrating a configuration example of the package according to the first embodiment, and b in the drawing is a plan view illustrating a configuration example of the package according to the first embodiment. In the drawing, a is a cross-sectional view taken along line A1-A2 of b in the drawing.

In the drawing, a package 100 includes an optical chip 111. The optical chip 111 is mounted on an interposer substrate 130.

An optical element is formed on the optical chip 111. The optical element may be a solid-state imaging element such as a charged coupled device (CCD) or a complementary metal-oxide semiconductor (CMOS). The light received by the solid-state imaging element may be visible light, near infrared light (NIR), short wavelength infrared light (SWIR), ultraviolet light, X-ray, or the like. The optical element may be a light receiving element such as a photo diode (PD), or may be a light emitting element such as a laser diode (LD), a light emitting diode (LED), or a vertical cavity surface emitting laser (VCSEL). The optical element may be a micro electro mechanical systems (MEMS) element such as an optical switch or a mirror device. The material used for the base material of the optical chip 111 may be a semiconductor such as Si, GaAS, or InGaAsP, or may be a dielectric such as LiNbO₃, glass, or a transparent resin. Note that, in the following description, a back-illuminated solid-state imaging element is taken as an example of the optical chip 111.

The optical chip 111 includes a semiconductor layer 112 and a wiring layer 113. The semiconductor layer 112 is provided with an imaging region and a non-imaging region. In the imaging region, pixels and pixel transistors disposed in a matrix along the row direction and the column direction are disposed. In the non-imaging region, a peripheral circuit that drives the pixel transistor and outputs a signal read from the pixel is provided.

On the back surface side of the semiconductor layer 112, an on-chip lens 116 is formed for each pixel. As the material of the on-chip lens 116, for example, a transparent resin such as acrylic or polycarbonate can be used. Note that a color filter may be provided for each pixel between the semiconductor layer 112 and the on-chip lens 116. At this time, the color filter can form, for example, a Bayer array.

Furthermore, on the back surface side of the semiconductor layer 112, a transparent resin 117 is formed so as to cover the on-chip lens 116. A transparent substrate 118 is disposed on the transparent resin 117. The material of the transparent resin 117 is, for example, silicone, acrylic, or polycarbonate. At this time, the refractive index of the transparent resin 117 can be made smaller than the refractive index of the on-chip lens 116. The material of the transparent substrate 118 may be, for example, quartz, glass, or Al₂O₃, CaF₂, MgF₂, LiF, or the like according to the wavelength of the optical element. The transparent resin 117 may be used as an adhesive for bonding the transparent substrate 118. The combined thickness of the transparent resin 117 and the transparent substrate 118 is preferably about 3 to 400 µm. Note that the transparent resin 117 and the transparent substrate 118 are examples of a transparent member described in the claims.

The wiring layer 113 is formed on the front surface side of the semiconductor layer 112. Wiring buried in the insulating layer is provided on the wiring layer 113. In addition, a pad electrode to which the through electrode 110 is connected can be formed on the wiring layer 113. The wiring layer 113 is supported by the support substrate 114. Land electrodes 115 are formed on the support substrate 114, and the through electrodes 110 are embedded in the support substrate 114. The wiring layer 113 is electrically connected to the land electrode 115 via the through electrode 110.

As the material of the insulating layer used for the wiring layer 113, for example, SiO₂ can be used. The material of the support substrate 114 can be, for example, Si or glass. As the material of the wiring and the pad electrode used for the wiring layer 113, for example, a metal such as Al or Cu can be used. As the material of the through electrode 110 and the land electrode 115, for example, a metal such as Cu, Ti, Ta, Al, W, Ni, Ru, or Co can be used, and a laminated structure of a plurality of materials may be used.

The interposer substrate 130 includes a support substrate 131 and a wiring layer 132. As the support substrate 131, for example, a semiconductor substrate such as Si, an organic substrate, or a ceramic substrate can be used. The land electrodes 133 are formed on the wiring layer 132. Wiring (not illustrated) may be formed on the wiring layer 132. The land electrodes 134 are formed on the back surface of the support substrate 131. A back surface wiring may be formed on the back surface of the support substrate 131. Further, through electrodes 135 are formed on the support substrate 131 and the wiring layer 132. The land electrodes 133 and 134 are electrically connected to each other via the through electrode 135. As the material of the through electrode 135 and the land electrodes 133 and 134, for example, metals such as Cu, Ti, Ta, Al, W, Ni, Ru, and Co can be used, and a laminated structure of a plurality of materials may be used. The thickness of the interposer substrate 130 is preferably 30 to 300 µm.

The land electrode 115 is connected to the land electrode 133 via a bump electrode 136. Note that the bump electrode 136 may be a solder ball or a pillar electrode.

In addition, an underfill 119 is provided between the interposer substrate 130 and the optical chip 111 and around the optical chip 111. The material of the underfill 119 is, for example, a thermosetting resin such as an epoxy resin.

Further, on the interposer substrate 130, a molding material 151 is disposed so as to surround the periphery of the optical chip 111. At this time, the molding material 151 can contact the side surface of the optical chip 111 and the side surface of the underfill 119. Further, the position of the end portion of the molding material 151 in a lateral direction DL and the position of the end portion of the interposer substrate 130 in the lateral direction DL can coincide with each other. At this time, the package 100 can be divided into a piece by cutting out the molding material 151 surrounding the periphery of the optical chip 111 together with the interposer substrate 130. The material of the molding material 151 may be a thermosetting resin such as an epoxy resin. As the material of the molding material 151, a silica filler may be mixed in a thermosetting resin. When the optical chip 111 is a light receiving element, a material having low reflectance and transmittance may be used in order to suppress flare and ghost due to reflected light from the molding material 151.

The surface of the molding material 151 is flattened at a position surrounding the periphery of the optical chip 111. The flat surface of the molding material 151 may be a polished surface. At this time, the transparent substrate 118 can be used as a stopper for polishing the molding material 151. The position of the flat surface of the molding material 151 in the height direction DH can be made substantially equal to the position of the top surface of the optical chip 111 in the height direction DH. Note that the position of the flat surface of the molding material 151 in the height direction DH is not necessarily strictly equal to the position of the top surface of the optical chip 111 in the height direction DH, and may be lower or higher than the position of the top surface of the optical chip 111 in the height direction DH.

As described above, in the first embodiment described above, the optical chip 111 in which the transparent substrate 118 is disposed on the upper side so as to be surrounded by the molding material 151 whose surface is flattened is mounted on the interposer substrate 130. This makes it possible to seal the optical chip 111 with the molding material 151 without impairing the optical function of the optical chip 111. Therefore, it is not necessary to use an expensive member such as a ceramic package in order to seal the optical chip 111, and it is possible to improve the reliability of the optical chip 111 while suppressing an increase in the cost of the package 100 on which the optical chip 111 is mounted.

### <2. Second embodiment>

In the first embodiment described above, the optical chip 111 in which the transparent substrate 118 is disposed on the upper side so as to surround the periphery with the molding material 151 whose surface is flattened is mounted on the interposer substrate 130. In the second embodiment, a semiconductor chip is retrofitted onto the interposer substrate 130 on which the optical chip 111 in which the transparent substrate 118 is disposed on the upper side so as to surround the periphery with the molding material 151 whose surface is flattened is mounted.

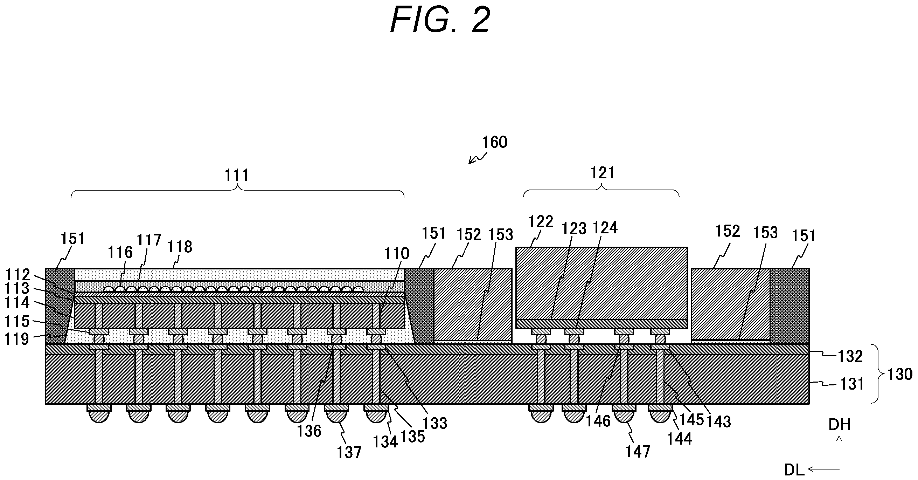

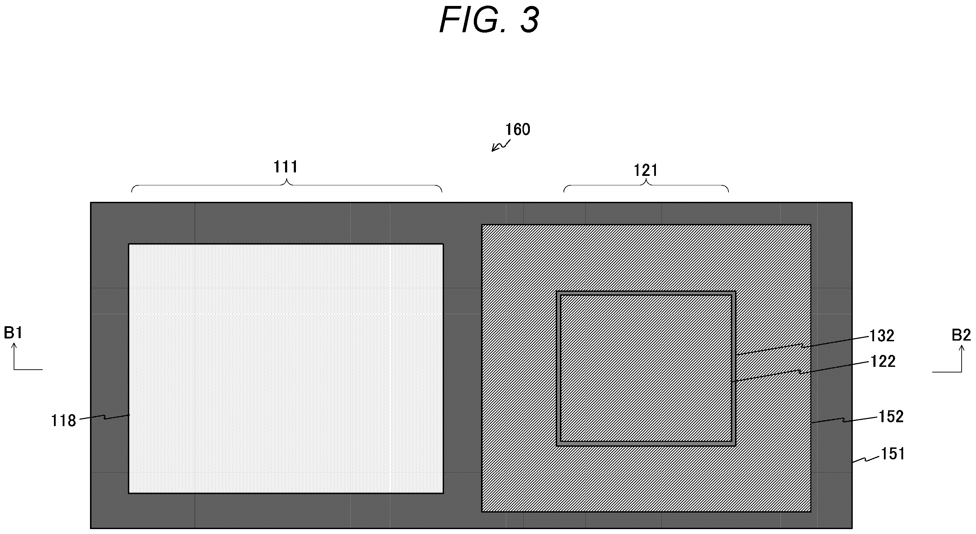

Fig. 2 is a cross-sectional view illustrating a configuration example of a package according to the second embodiment, and Fig. 3 is a plan view illustrating a configuration example of the package according to the second embodiment. Fig. 2 is a cross-sectional view taken along line B1-B2 in Fig. 3.

In Figs. 2 and 3, in a package 160, a semiconductor chip 121 and a dummy chip 152 are added to the package 100 of the first embodiment described above. In addition, land electrodes 143 and 144 and through electrodes 145 are added to the interposer substrate 130. Other configurations of the package 160 of the second embodiment are similar to those of the package 100 of the first embodiment described above.

The optical chip 111 and the semiconductor chip 121 are mounted on the interposer substrate 130. Note that the semiconductor chip 121 is an example of a chip described in the claims.

A semiconductor element is formed on the semiconductor chip 121. The semiconductor element may include a transistor, a resistor, a capacitor, and the like. In the semiconductor chip 121, a memory may be formed, a processor may be formed, a signal processing circuit may be formed, a data processing circuit may be formed, an interface circuit may be formed, or an optical element may be formed. In the semiconductor chip 121, for example, a hardware circuit such as a field-programmable gate array (FPGA) or an application specific integrated circuit (ASIC) may be formed. The material used for the base material of the semiconductor chip 121 may be Si, GaAS, SiC, GaN, InGaAsP, or the like.

The semiconductor chip 121 includes a semiconductor substrate 122 and a wiring layer 123. The wiring layer 123 is formed on the semiconductor substrate 122. Wiring buried in the insulating layer is provided on the wiring layer 123. Further, land electrodes 124 to which bump electrodes 146 are connected can be formed on the wiring layer 123.

The land electrodes 143 are formed on the wiring layer 132 of the interposer substrate 130 in addition to the land electrodes 133. The land electrodes 144 are formed on the back surface of the support substrate 131 in addition to the land electrodes 134. In addition to the through electrodes 135, the through electrodes 145 are formed on the support substrate 131 and the wiring layer 132. The land electrodes 143 and 144 are electrically connected to each other via the through electrode 145. As the material of the through electrode 145 and the land electrodes 143 and 144, for example, metals such as Cu, Ti, Ta, Al, W, Ni, Ru, and Co can be used, and a laminated structure of a plurality of materials may be used.

The land electrode 124 is connected to the land electrode 143 via the bump electrode 146. Note that the bump electrode 146 may be a solder ball or a pillar electrode.

Further, on the interposer substrate 130, the dummy chip 152 is disposed so as to surround the periphery of the semiconductor chip 121. The dummy chip 152 can be disposed on the interposer substrate 130 while being separated from the semiconductor chip 121. The dummy chip 152 can be fixed to the interposer substrate 130 via an adhesive 153. The surface of the dummy chip 152 is flattened. The position of the flat surface of the dummy chip 152 in the height direction DH can be made substantially equal to the position of the top surface of the optical chip 111 in the height direction DH. Note that the position of the flat surface of the dummy chip 152 in the height direction DH is not necessarily strictly equal to the position of the top surface of the optical chip 111 in the height direction DH, and may be lower or higher than the position of the top surface of the optical chip 111 in the height direction DH. The material of the dummy chip 152 may be a semiconductor such as Si or an inorganic material such as glass or ceramics. Note that, although Fig. 3 illustrates an example in which the semiconductor chip 121 is disposed at the central portion of the dummy chip 152, the dummy chip may be disposed in a region including front, rear, left, and right end portions. In addition, the dummy chip 152 may not be provided.

The molding material 151 is disposed on the interposer substrate 130 so as to surround a periphery of each of the optical chip 111 and the dummy chip 152. At this time, the molding material 151 can contact the side surface of the optical chip 111, the side surface of the underfill 119, and the outer peripheral surface of the dummy chip 152. Further, the position of the end portion of the molding material 151 in a lateral direction DL and the position of the end portion of the interposer substrate 130 in the lateral direction DL can coincide with each other.

The surface of the molding material 151 is flattened at a position surrounding the periphery of each of the optical chip 111 and the dummy chip 152. The flat surface of the molding material 151 may be a polished surface. At this time, the transparent substrate 118 can be used as a stopper for polishing the molding material 151. The position of the flat surface of the molding material 151 in the height direction DH can be made substantially equal to the position of the top surface of the optical chip 111 in the height direction DH. The top surface of the optical chip 111 is a surface of the transparent substrate 118.

Note that, in the second embodiment described above, an example in which two chips are mounted on the interposer substrate 130 has been described, but three or more chips may be mounted on the interposer substrate 130. In a case where there are two or more chips having a top surface substantially equal to the position of the flat surface of the molding material 151 in the height direction DH, not all the chips may be optical chips, and at least one optical chip may be included. In a case where a chip having a top surface substantially equal to the position of the flat surface of the molding material 151 in the height direction DH is not an optical chip, the surface of the chip may not be a transparent resin or a transparent substrate.

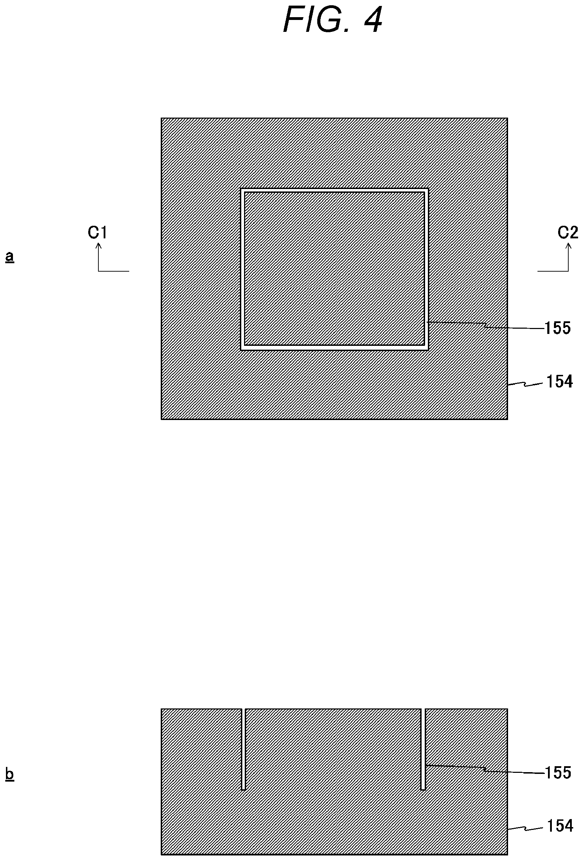

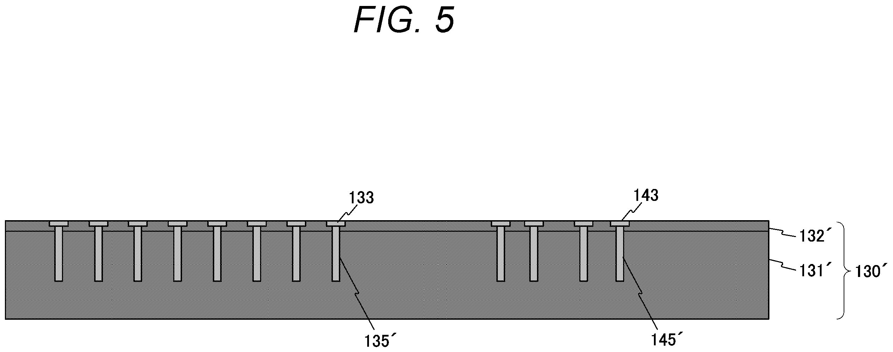

Fig. 4 is a cross-sectional view and a plan view illustrating an example of a method for manufacturing a package according to the second embodiment, and Figs. 5 to 14 are cross-sectional views illustrating an example of the method for manufacturing a package according to the second embodiment. Note that b in Fig. 4 is a cross-sectional view taken along line C1-C2 of a in Fig. 4.

In Fig. 4, a groove 155 continuous in a rectangular shape is formed in the dummy substrate 154. The groove 155 can be formed along the inner peripheral surface of the dummy chip 152. At this time, by thinning the dummy substrate 154 from the surface opposite to the surface on which the groove 155 is formed to the position of the groove 155, the dummy chip 152 can be separated from the dummy substrate 154 along the groove 155. The depth of the groove 155 is set larger than the height of the dummy chip 152. For example, the depth of the groove 155 is about 20 to 400 µm. The material of the dummy substrate 154 may be a semiconductor such as Si or an inorganic material such as glass or ceramics. Lithography and dry etching or laser machining or cutting may be used to form the groove 155. Note that, in a case where the dummy chip 152 is not provided in the package 160, the groove 155 is unnecessary.

Next, as illustrated in Fig. 5, an interposer wafer 130' is formed. A plurality of interposer substrates 130 used for the package 160 in Fig. 2 can be cut out from the interposer wafer 130'. At this time, buried electrodes 135' and 145' are then formed in the interposer wafer 130'. Here, the thickness of the support substrate wafer 131' is greater than the depth of the buried electrodes 135' and 145'. Also, the depth of the buried electrodes 135' and 145' is equal to the length of the through electrodes 135 and 145. Then, the wiring layer 132' having the land electrodes 133 and 143 formed on the surface thereof is formed on the support substrate wafer 131'. At this time, each of the land electrodes 133 and 143 is formed at a position connected to the buried electrodes 135' and 145'.

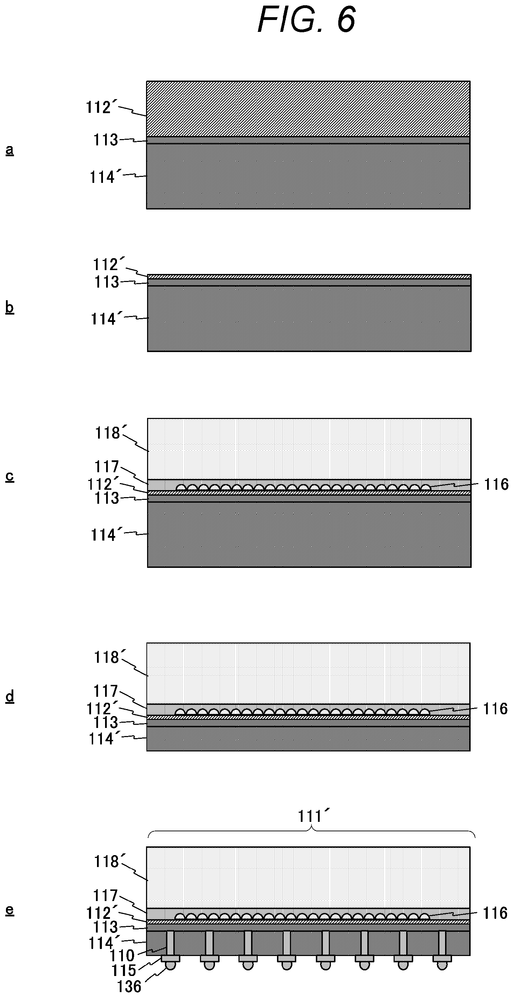

Next, as illustrated in a in Fig. 6, the optical element is formed on a semiconductor wafer 112' for each chip. In the case of forming a back-illuminated solid-state imaging element as an optical element, a photodiode can be formed on the semiconductor wafer 112' for each chip. Next, the wiring layer 113 is formed on the semiconductor wafer 112'. Next, the semiconductor wafer 112' is bonded to a support substrate wafer 114' via the wiring layer 113.

Next, as illustrated in b in Fig. 6, the semiconductor wafer 112' is thinned from the back surface side by a method such as chemical mechanical polishing (CMP). At this time, a light-receiving surface is formed on the back surface side of the semiconductor wafer 112' after thinning.

Next, as illustrated in c in Fig. 6, the on-chip lens 116 is formed on the back surface side of the semiconductor wafer 112'. Color filters may be formed on the semiconductor wafer 112' prior to forming the on-chip lens 116. Then, the transparent resin 117 is applied onto the semiconductor wafer 112' so as to cover the on-chip lens 116, and a transparent wafer 118' is bonded to the semiconductor wafer 112' via the transparent resin 117.

Next, as illustrated in d in Fig. 6, the support substrate wafer 114' is thinned by a method such as CMP.

Next, as illustrated in e in Fig. 6, the through electrode 110 electrically connected to the wiring layer 113 is formed on the support substrate wafer 114'. Next, the land electrode 115 is formed on the back surface side of the support substrate wafer 114', and is connected to the through electrode 110 by back surface wiring or the like. Next, the bump electrode 136 is formed on the land electrode 115. Next, the semiconductor wafer 112' supported by the support substrate wafer 114' is cut together with the transparent wafer 118' by blade dicing or the like, and is divided into a piece so as to have the same plane size as the optical chip 111 in Fig. 2. At this time, the optical chip 111' before the transparent substrate 118 in Fig. 2 is thinned is formed.

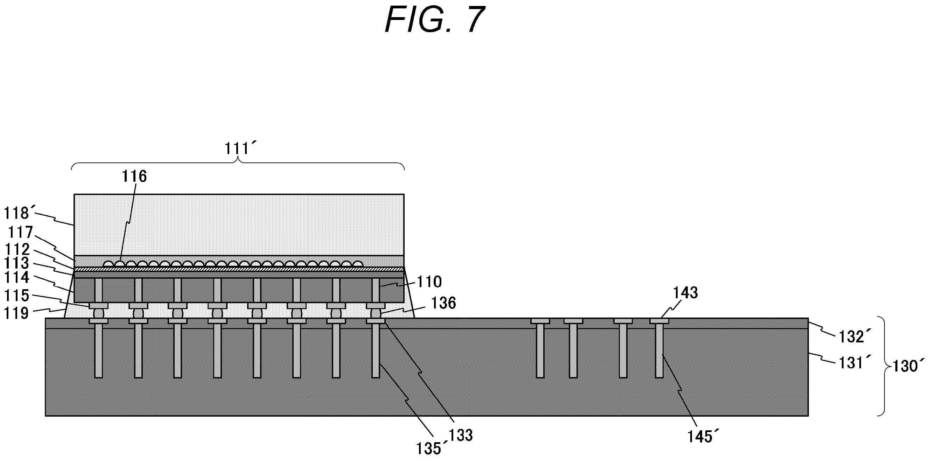

The optical chip 111' is then mounted on the interposer wafer 130' as shown in Fig. 7. Here, a plurality of optical chips 111' can be mounted laterally side by side on one interposer wafer 130'. At this time, the land electrode 115 of the optical chip 111' is connected to the land electrode 133 via the bump electrode 136. In a case where the bump electrode 136 is a solder bump, the bump electrode 136 may be bonded to the land electrode 133 by thermal reflow or the like. Next, the underfill 119 is filled between the interposer wafer 130' and the optical chip 111' and around the optical chip 111'.

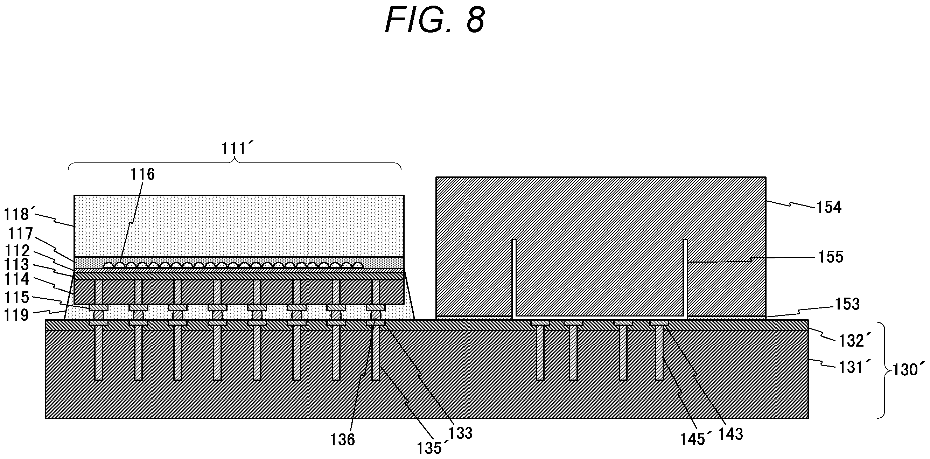

Next, as shown in Fig. 8, a plurality of dummy substrates 154 is placed on the interposer wafer 130' so as to be adjacent to each of the plurality of optical chips 111' mounted on the interposer wafer 130'. The dummy substrate 154 may adhere onto the interposer wafer 130' via the adhesive 153. Here, the adhesive 153 is prevented from being attached to an inner region surrounded by the groove 155 in the lower surface of the dummy substrate 154. At this time, a gap is formed between an inner region surrounded by the groove 155 on the lower surface of the dummy substrate 154 and the interposer wafer 130'.

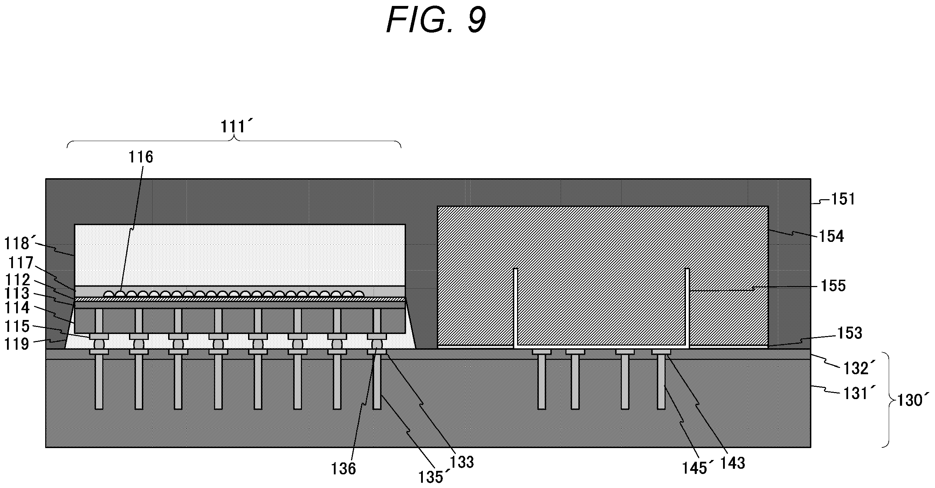

Next, as shown in Fig. 9, the molding material 151 is formed on the interposer wafer 130' such that all the optical chips 111' and the dummy substrate 154 on the interposer wafer 130' are covered. At this time, the molding material 151 is disposed not only around each of the optical chip 111' and the dummy substrate 154 but also above each of the optical chip 111' and the dummy substrate 154.

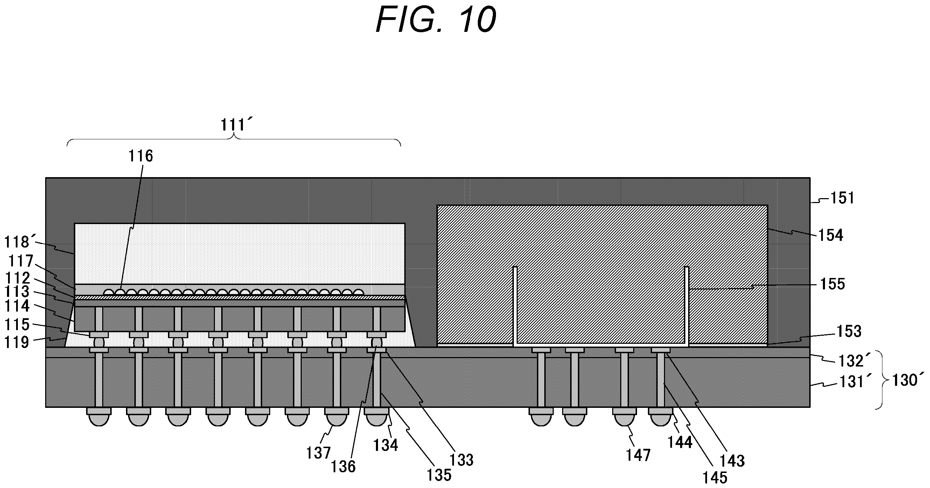

Next, as illustrated in Fig. 10, the interposer wafer 130' is thinned, and the buried electrodes 135' and 145' are exposed from the back surface side, thereby forming the through electrodes 135 and 145 on the interposer wafer 130'. Methods such as grinder, CMP, or dry etching can be used to thin the interposer wafer 130'. Further, the land electrodes 134 and 144 electrically connected to the respective through electrodes 135 and 145 are formed on the back surface side of the interposer wafer 130', and bump electrodes 137 and 147 are formed on the respective land electrodes 134 and 144.

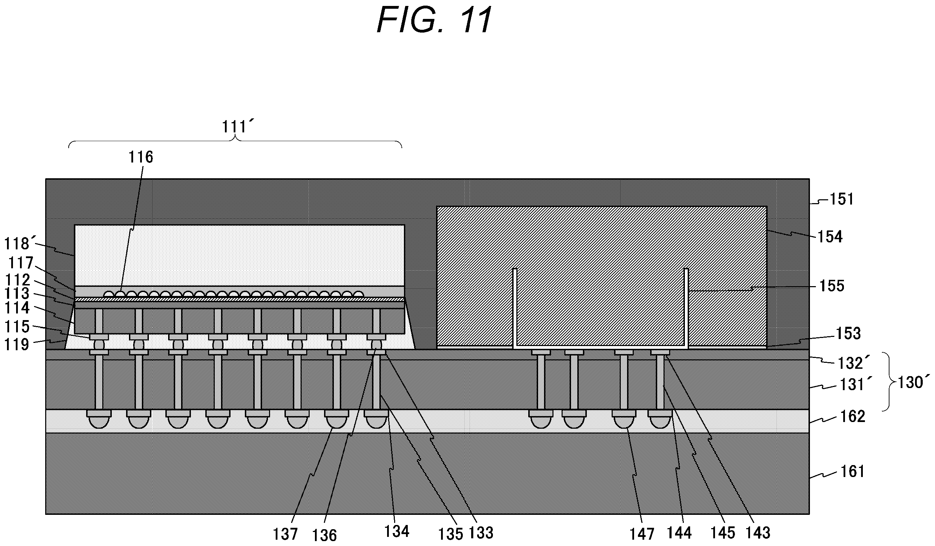

Next, as illustrated in Fig. 11, a dummy wafer 161 is temporarily bonded to the back surface of the interposer wafer 130' via an adhesive 162. The material of the dummy wafer 161 may be Si or glass.

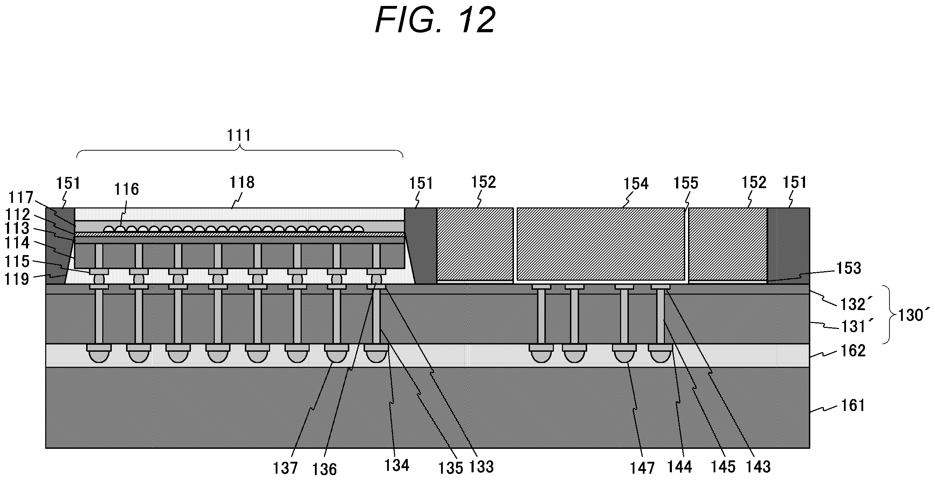

Next, as shown in Fig. 12, the molding material 151 is polished from the upper surface side thereof to be flattened and thinned. CMP, a grinder, plasma etching, or the like can be used for polishing the molding material 151. At this time, the transparent substrate 118 can be used as a stopper for polishing the molding material 151, and the polishing of the molding material 151 can be stopped when the entire surface of the transparent substrate 118 is exposed. Thus, the optical chip 111 surrounded by the molding material 151 can be formed on the interposer wafer 130', and the molding material 151 can be prevented from hindering the optical function of the optical chip 111. In addition, the dummy substrate 154 is also thinned along with the thinning of the molding material 151, and the groove 155 penetrates the dummy substrate 154. Therefore, the inner portion and the outer portion of the dummy substrate 154 are separated with the groove 155 as a boundary. At this time, the outer portion of the dummy substrate 154 is fixed on the interposer wafer 130' via the adhesive 153, and can be used as the dummy chip 152. The inner portion of the dummy substrate 154 is separated from the dummy chip 152 and the interposer wafer 130'.

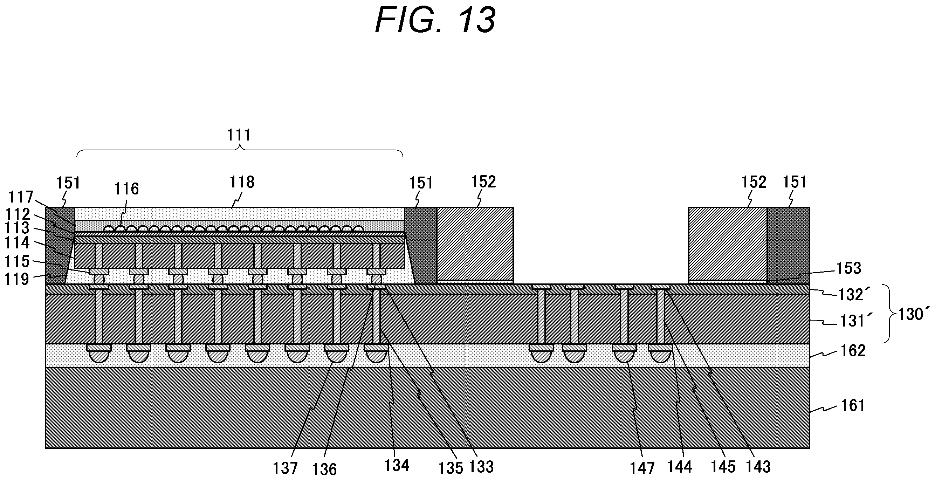

Next, as illustrated in Fig. 13, the dummy substrate 154 inside the dummy chip 152 is removed. The dummy substrate 154 inside the dummy chip 152 is not adhered to the interposer wafer 130' with the adhesive 153 and can thus be easily removed.

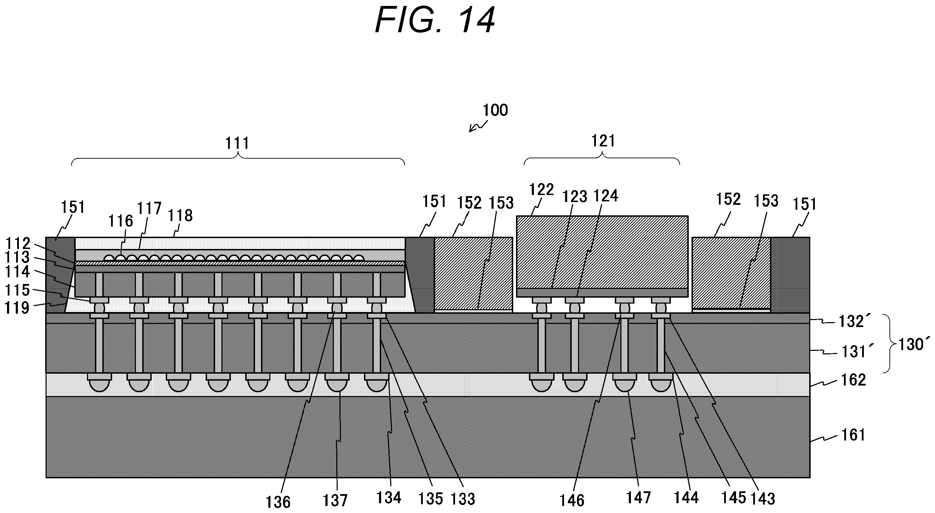

Next, as illustrated in Fig. 14, the semiconductor chip 121 is mounted on the interposer wafer 130' so as to be located inside the dummy chip 152. At this time, the land electrode 124 of the semiconductor chip 121 is connected to the land electrode 143 via the bump electrode 146. When the bump electrode 146 is a solder bump, the bump electrode 146 may be bonded to the land electrode 143 by thermal reflow or the like. Here, the semiconductor chips 121 can be mounted on the interposer wafer 130' before the interposer wafer 130' on which the dummy chip 152 is mounted is divided into the individual semiconductor chip 121. As a result, it is not necessary to individually align the interposer wafer 130' that has been divided before the semiconductor chip 121 is mounted, and the mounting of the semiconductor chip 121 can be made efficient.

Next, as illustrated in Fig. 2, the dummy wafer 161 and the adhesive 162 are debonded. Then, the interposer wafer 130' on which the optical chip 111 and the semiconductor chip 121 are mounted is divided into a piece together with the molding material 151 to form the package 160. Note that, the timing of debonding the dummy wafer 161 and the adhesive 162 may be after the step in Fig. 12, after the step in Fig. 13, or after the step in Fig. 14.

Note that the present manufacturing method is an example, and for example, the dummy substrate 154 may be removed by a method such as plasma etching. Alternatively, the dummy substrate 154 may be bonded using an adhesive for temporary bonding, and the entire dummy substrate 154 may be removed in a subsequent step.

As described above, in the second embodiment described above, the semiconductor chip 121 is retrofitted onto the interposer substrate 130 on which the optical chip 111 in which the transparent substrate 118 is disposed on the upper side is mounted so as to surround the periphery with the molding material 151 whose surface is flattened. This makes it possible to seal the optical chip 111 with the molding material 151 without impairing the optical function of the optical chip 111, and to suppress an increase in the mounting area of the package 160 on which the optical chip 111 and the semiconductor chip 121 are mounted.

In addition, by providing the dummy chip 152 around the semiconductor chip 121, even when the planar size of the semiconductor chip 121 is smaller than the planar size of the optical chip 111, the section of the mounting region of the chip on the interposer wafer 130' can be made uniform. For this reason, after the packaging of the plurality of packages coupled via the interposer wafer 130' is collectively performed, the plurality of packages can be divided into the individual packages 160 by blade dicing or the like, and the packaging can be made efficient.

### <3. Third embodiment>

In the first embodiment described above, the semiconductor chip 121 is retrofitted on the interposer substrate 130 on which the optical chip 111 in which the transparent substrate 118 is disposed on the upper side is mounted so as to surround the periphery with the molding material 151 whose surface is flattened. In the third embodiment, an optical functional layer is provided on the transparent substrate 118, and a periphery of an optical chip provided with the optical functional layer is surrounded by the molding material 151.

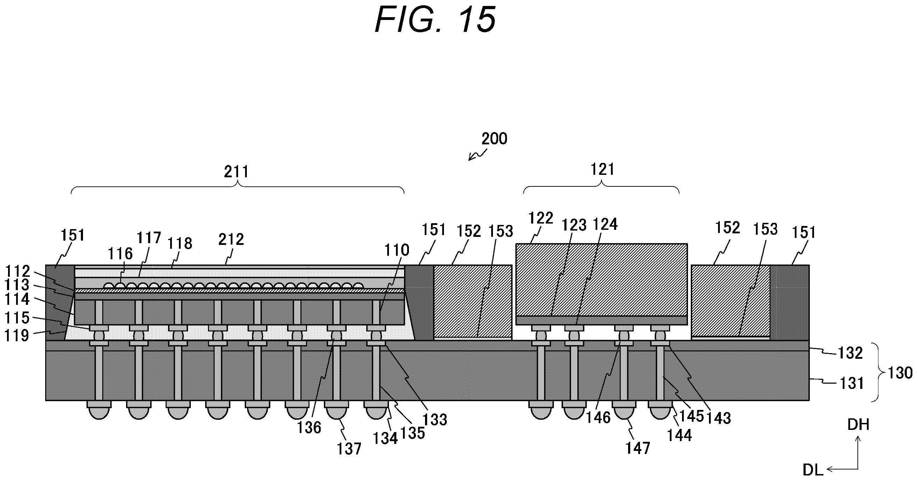

Fig. 15 is a cross-sectional view illustrating a configuration example of a package according to the third embodiment.

In the drawing, the package 200 includes an optical chip 211 instead of the optical chip 111 of the package 160 of the second embodiment described above. In the optical chip 211, an optical functional layer 212 is added to the optical chip 111 of the second embodiment described above. Other configurations of the package 200 of the third embodiment are similar to those of the package 160 of the second embodiment described above.

The optical functional layer 212 is disposed on the transparent substrate 118. The optical functional layer 212 is, for example, an antireflection layer, an optical filter, a lens, a mirror, or the like. The molding material 151 is disposed on the interposer substrate 130 so as to surround the periphery of each of the optical chip 211 and the dummy chip 152. The position of the flat surface of the molding material 151 in the height direction DH can be made substantially equal to the position of the top surface of the optical chip 211 in the height direction DH. The top surface of the optical chip 211 is a surface of the optical functional layer 212.

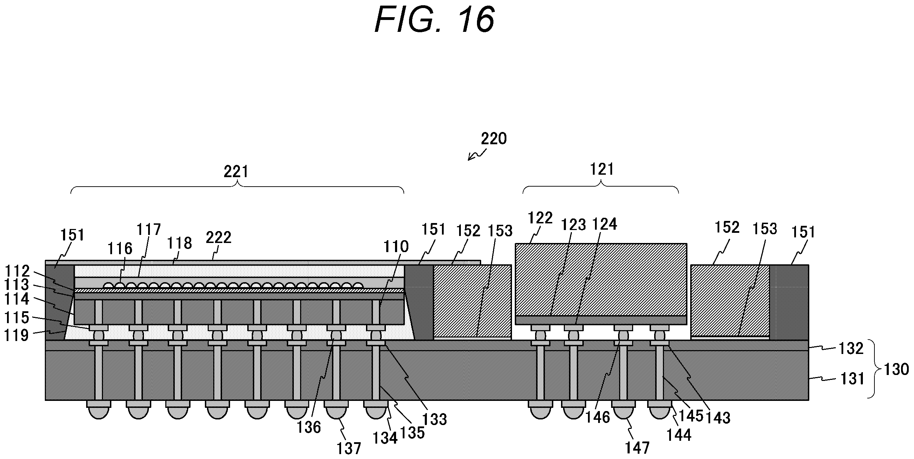

Fig. 16 is a cross-sectional view illustrating a modification of the configuration of the package according to the third embodiment.

In the drawing, in the package 220, an optical functional layer 222 is added to the package 160 of the second embodiment described above. Other configurations of the package 220 are similar to those of the package 160 of the second embodiment described above.

The optical functional layer 222 is disposed on the transparent substrate 118. Further, the optical functional layer 222 is extended on the molding material 151 and the dummy chip 152. The optical functional layer 222 is, for example, an antireflection layer, an optical filter, a lens, a mirror, or the like.

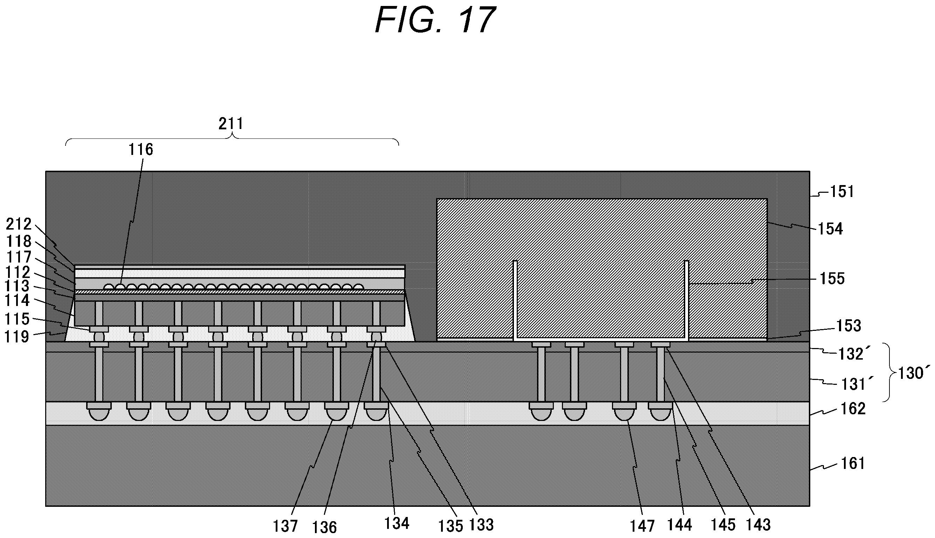

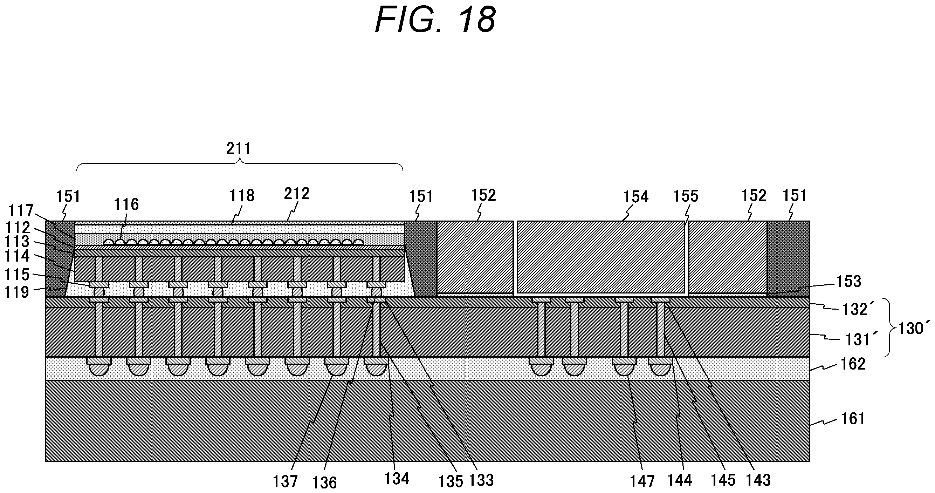

Figs. 17 and 18 are cross-sectional views illustrating an example of a method for manufacturing a package according to the third embodiment. Note that Figs. 17 and 18 illustrate a method for manufacturing a package 200 in Fig. 15.

In Fig. 17, in the optical chip 211, the optical functional layer 212 is formed on the transparent substrate 118. Here, the thickness of the transparent substrate 118 is thinner than the thickness of the transparent substrate 118' in Fig. 10. For example, the position of the surface of the transparent substrate 118 may be lower than the position of the bottom of the groove 155 of the dummy substrate 154. At this time, the molding material 151 is disposed not only around each of the optical chip 211 and the dummy substrate 154 but also above each of the optical chip 211 and the dummy substrate 154.

Next, as shown in Fig. 18, the molding material 151 is polished from the upper surface side thereof to be flattened and thinned. CMP, a grinder, plasma etching, or the like can be used for polishing the molding material 151. At this time, the optical functional layer 212 can be used as a stopper for polishing the molding material 151, and the polishing of the molding material 151 can be stopped when the entire surface of the optical functional layer 212 is exposed. Thus, the optical chip 211 surrounded by the molding material 151 can be formed on the interposer wafer 130', and the molding material 151 can be prevented from hindering the optical function of the optical chip 211. Note that a dummy layer or the like may be provided on the optical functional layer 212 and removed after the molding material 151 is polished.

As described above, in the third embodiment described, by disposing the optical functional layer 212 on the transparent substrate 118, the performance of the optical chip 211 can be improved without increasing the planar size of the package 200.

### <4. Fourth embodiment>

In the second embodiment described above, the semiconductor chip 121 is retrofitted on the interposer substrate 130 on which the optical chip 111 in which the transparent substrate 118 is disposed on the upper side is mounted so as to surround the periphery with the molding material 151 whose surface is flattened. In the fourth embodiment, the semiconductor chip 121 is retrofitted onto the extended rewiring layer 311 on which the optical chip 111 in which the transparent substrate 118 is disposed on the upper side is mounted so as to surround the periphery with the molding material 151 whose surface is flattened.

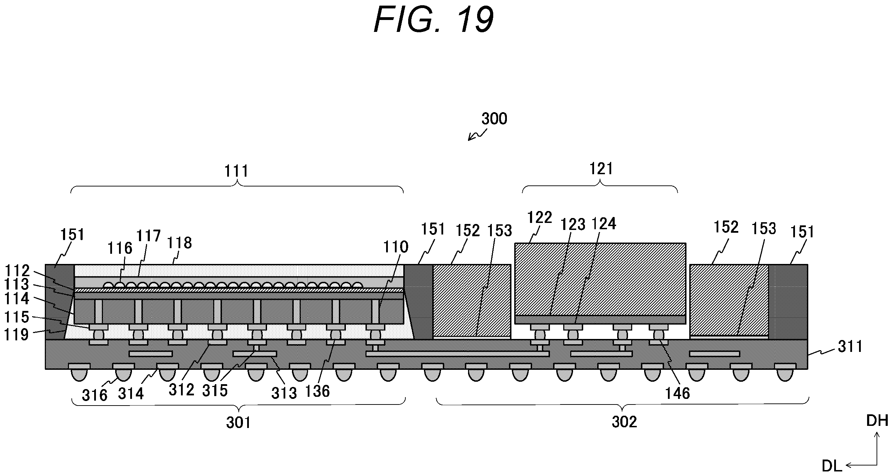

Fig. 19 is a cross-sectional view illustrating a configuration example of a package according to the fourth embodiment.

In the drawing, the package 300 includes the extended rewiring layer 311 instead of the interposer substrate 130 of the package 160 of the second embodiment described above. Other configurations of the package 300 of the fourth embodiment are similar to those of the package 160 of the second embodiment described above.

In the extended rewiring layer 311, a wiring 313 is formed, and a via 315 for interlayer-connecting the wiring 313 is formed. Further, a land electrode 312 is formed on the front surface side of the extended rewiring layer 311, and a land electrode 314 is formed on the back surface side of the extended rewiring layer 311. As the material of the insulating layer used for the extended rewiring layer 311, for example, a photosensitive insulating resin having SiO₂, SiON, SiN, SiOC or SiCN can be used in the case of an inorganic film, and a photosensitive insulating resin having silicone, polyimide, acrylic, epoxy or the like as a skeleton can be used in the case of an organic film. As the materials of the wiring 313, the land electrodes 312 and 314, and the via 315, for example, metals such as Cu, Ti, Ta, Al, W, Ni, Ru, and Co can be used, and a laminated structure of a plurality of materials may be used. The bump electrode 316 is formed on the land electrode 314. Note that the bump electrode 316 may be a solder ball or a pillar electrode. The extended rewiring layer 311 can be formed in a manner similar to a rewiring layer used for a fan out wafer level package (FOWLP).

The extended rewiring layer 311 is electrically connected to the wiring layer 113 of the optical chip 111, and includes an extended region 302 extended in the lateral direction DH from the mounting region 301 of the optical chip 111. At this time, the semiconductor chip 121 and the dummy chip 152 are mounted on the extended region 302 of the extended rewiring layer 311. The dummy chip 152 can be fixed to the extended rewiring layer 311 via the adhesive 153. The land electrode 115 is electrically connected to the land electrode 312 via the bump electrode 136, and the land electrode 124 is electrically connected to the land electrode 312 via the bump electrode 146.

The underfill 119 is provided between the extended rewiring layer 311 and the optical chip 111 and around the optical chip 111.

The molding material 151 is disposed on the extended rewiring layer 311 so as to surround a periphery of each of the optical chip 111 and the dummy chip 152. At this time, the molding material 151 can contact the side surface of the optical chip 111, the side surface of the underfill 119, and the outer peripheral surface of the dummy chip 152.

Further, the position of the end portion of the molding material 151 in the lateral direction DL and the position of the end portion of the extended rewiring layer 311 in the lateral direction DL can coincide with each other. At this time, the packages 300 can be divided into pieces by blade dicing or the like from a state in which the plurality of packages 300 is integrated into a wafer shape.

As described above, in the fourth embodiment described above, the semiconductor chip 121 is mounted on the extended rewiring layer 311 extended in the lateral direction DL from the mounting region 301 of the optical chip 111 in which the transparent substrate 118 is disposed on the upper side so as to surround the periphery with the molding material 151. As a result, the package 300 can be made thinner and the cost can be reduced as compared with the case where the interposer substrate 130 is used to mount the optical chip 111 and the semiconductor chip 121.

### <5. Fifth embodiment>

In the second embodiment described above, the optical chip 111 is provided at a position where the molding material 151 is in contact, and the semiconductor chip 121 is provided at a position surrounded by the dummy chip 152. In the fifth embodiment, a semiconductor chip is provided at a position where the molding material 151 is in contact, and an optical chip is provided at a position surrounded by the dummy chip 152.

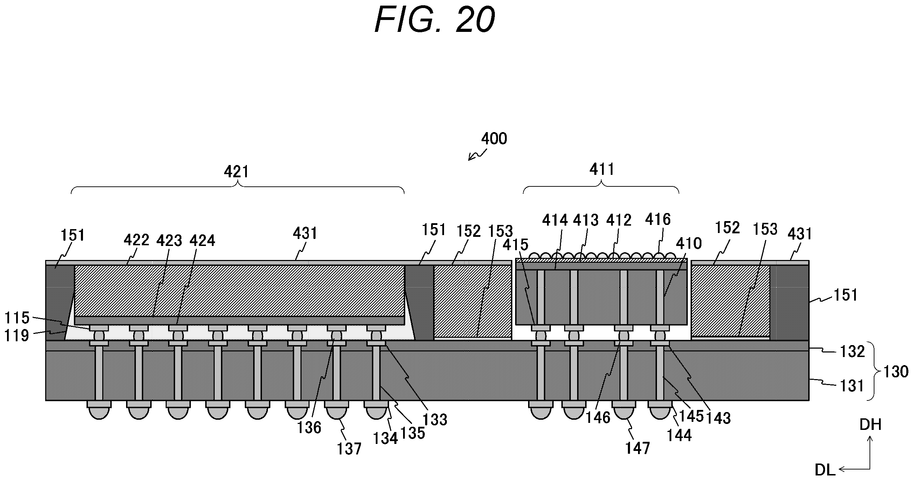

Fig. 20 is a cross-sectional view illustrating a configuration example of a package according to the fifth embodiment.

In the drawing, the package 400 includes an optical chip 411 and a semiconductor chip 421 instead of the optical chip 111 and the semiconductor chip 121 of the package 160 of the second embodiment described above. Further, in the package 400, an antireflection film 431 is added to the package 160 of the second embodiment described above. Other configurations of the package 400 of the fifth embodiment are similar to those of the package 160 of the second embodiment described above.

The optical chip 411 and the semiconductor chip 421 are mounted on the interposer substrate 130.

An optical element is formed on the optical chip 411. The optical chip 411 includes a semiconductor layer 412 and a wiring layer 413. A light-receiving surface is formed on the semiconductor layer 412. On the back surface side of the semiconductor layer 412, an on-chip lens 416 is formed for each pixel. The wiring layer 413 is formed on the front surface side of the semiconductor layer 412. The wiring layer 413 is supported by the support substrate 414. Land electrodes 415 are formed on the support substrate 414, and through electrodes 410 are embedded in the support substrate 414. The wiring layer 413 is electrically connected to the land electrode 415 via the through electrode 410. Further, the land electrode 415 is electrically connected to the land electrode 143 through the bump electrode 146.

The dummy chip 152 is disposed around the optical chip 411. The dummy chip 152 can be disposed on the interposer substrate 130 while being separated from the optical chip 411. At this time, the position of the top surface of the optical chip 411 in the height direction DH can be made higher than the positions of the flat surfaces of the molding material 151 and the dummy chip 152 in the height direction DH. For example, the light emitting surface of the optical chip 411 may be at a position higher than the flat surfaces of the molding material 151 and the dummy chip 152.

A semiconductor element is formed on the semiconductor chip 421. For example, a signal processing circuit, a memory, an optical element, or the like may be formed on the semiconductor chip 421. Instead of the semiconductor chip 421, the optical chip 111 may be mounted on the interposer substrate 130. The semiconductor chip 421 includes a semiconductor substrate 422 and a wiring layer 423. The wiring layer 423 is formed on the semiconductor substrate 422. Wiring buried in the insulating layer is provided on the wiring layer 423. Further, land electrodes 424 to which the bump electrodes 136 are connected can be formed on the wiring layer 423.

The underfill 119 is provided between the interposer substrate 130 and the semiconductor chip 421 and around the semiconductor chip 421. Further, on the interposer substrate 130, the molding material 151 is disposed so as to surround the periphery of the semiconductor chip 421. At this time, the molding material 151 can contact the side surface of the semiconductor chip 421 and the side surface of the underfill 119.

The antireflection film 431 is formed on the semiconductor chip 421, the dummy chip 152, and the molding material 151. By providing the antireflection film 431 in the package 400, it is possible to suppress flare and ghost due to reflected light from the semiconductor chip 421, the dummy chip 152, and the molding material 151.

As the antireflection film 431, a black color filter can be used. In a case where a black color filter is used as the antireflection film 431, a resin can be used as the material of the antireflection film 431. As the material of the antireflection film 431, it is possible to use a hafnium oxide (HfO₂), an aluminum oxide (Al₂O₃) film, a zirconium oxide (ZrO₂) film, a tantalum oxide (Ta₂O₃) film, a titanium oxide (TiO₂) film, a lanthanum oxide (La₂O₃) film, a praseodymium oxide (Pr₂O₃) film, a cerium oxide (CeO₂) film, a neodymium oxide (Nd₂O₃) film, a promethium oxide (Pm₂O₃) film, a samarium oxide (Sm₂O₃) film, a europium oxide (Eu₂O₃) film, a gadolinium oxide (Gd₂O₃) film, a terbium oxide (Tb₂O₃) film, a dysprosium oxide (Dy₂O₃) film, a holmium oxide (Ho₂O₃) film, a thulium oxide (Tm2O₃) film, a ytterbium oxide (Yb₂O₃) film, a lutetium oxide (Lu₂O₃) film, a yttrium oxide (Y₂O₃) film, a hafnium nitride film, an aluminum nitride film, a hafnium oxynitride film, or an aluminum oxynitride film. A method for forming these films may be a chemical vapor deposition (CVD) method, a physical vapor deposition (PVD) method, or an atomic layer deposition (ALD) method.

As described above, in the fifth embodiment described above, the optical chip 411 is mounted on the interposer substrate 130 so as to be surrounded by the dummy chip 152. As a result, after the semiconductor chip 421 is mounted on the interposer substrate 130, the optical chip 411 can be mounted on the interposer substrate 130, and thermal damage or the like to the optical chip 411 due to the mounting of the semiconductor chip 421 can be suppressed.

In addition, the position of the top surface of the optical chip 411 in the height direction DH is made higher than the position of the flat surface of the dummy chip 152 in the height direction DH. As a result, it is possible to prevent the dummy chip 152 from hindering the incidence of light on the optical chip 411, and it is possible to maintain the optical characteristics of the optical chip 411.

### <6. Sixth embodiment>

In the first embodiment described above, the optical chip 111 in which the transparent substrate 118 is disposed on the upper side so as to surround the periphery with the molding material 151 whose surface is flattened is mounted on the interposer substrate 130. In the sixth embodiment, a dummy chip that supports the transparent member located on the upper side of the optical chip is mounted on the interposer substrate 130 together with the optical chip.

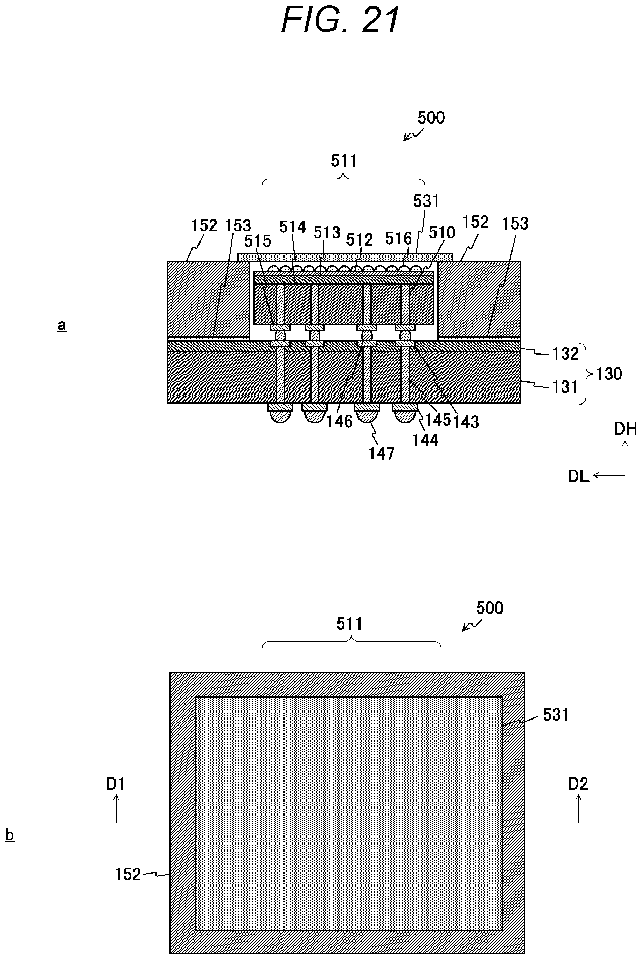

Fig. 21 is a diagram illustrating a configuration example of a package according to the sixth embodiment. Note that a in the drawing is a cross-sectional view illustrating a configuration example of the package according to the sixth embodiment, and b in the drawing is a plan view illustrating a configuration example of the package according to the sixth embodiment. In the drawing, a is a cross-sectional view taken along line D1-D2 of b in the drawing.

In the drawing, the package 500 includes an optical chip 511 and a dummy chip 152. The optical chip 511 is mounted on the interposer substrate 130. The dummy chip 152 is mounted on the interposer substrate 130 so as to surround the periphery of the optical chip 511. The dummy chip 152 can be disposed on the interposer substrate 130 while being separated from the optical chip 511.

An optical element is formed on the optical chip 511. The optical chip 511 includes a semiconductor layer 512 and a wiring layer 513. A light-receiving surface is formed on the semiconductor layer 512. On the back surface side of the semiconductor layer 512, an on-chip lens 516 is formed for each pixel. A wiring layer 513 is formed on the front surface side of the semiconductor layer 512. The wiring layer 513 is supported by the support substrate 514. Land electrodes 515 are formed on the support substrate 514, and through electrodes 510 are embedded in the support substrate 514. The wiring layer 513 is electrically connected to the land electrode 515 via the through electrode 510. Further, the land electrode 515 is electrically connected to the land electrode 143 through the bump electrode 146. The position of the top surface of the optical chip 511 in the height direction DH can be lower than the position of the flat surface of the dummy chip 152 in the height direction DH. In the example in Fig. 21, the top surface of the optical chip 511 is the top surface of the on-chip lens 516. At this time, the flat surface of the dummy chip 152 can protrude in the height direction DH from the top surface of the optical chip 511.

Further, the position of the end portion of the dummy chip 152 in the lateral direction DL and the position of the end portion of the interposer substrate 130 in the lateral direction DL can coincide with each other. At this time, the packages 500 can be divided into pieces by blade dicing or the like from a state in which the plurality of packages 500 is integrated into a wafer shape. For example, the optical chip 511 is mounted on the interposer wafer in a state where the dummy wafer from which the plurality of dummy chips 152 can be cut out and the interposer wafer from which the plurality of interposer substrates 130 can be cut out are bonded to each other. Then, the bonded wafer on which the optical chip 511 is mounted is cut by blade dicing or the like, whereby the packages 500 can be divided into pieces.

A transparent member 531 is provided on the upper side of the optical chip 511. The transparent member 531 is supported by the dummy chip 152 at a position separated from the optical chip 511. At this time, the end portion of the transparent member 531 may be supported at the position of the shoulder inside the dummy chip 152. The transparent member 531 may be a transparent substrate, a lens, an optical filter, a mirror, a prism, or a combination of a plurality of them. The material of the transparent member 531 may be glass or quartz, or Al₂O₃, CaF₂, MgF₂, LiF, or the like depending on the wavelength of the optical element.

As described above, in the sixth embodiment described above, the dummy chip 152 supporting the transparent member 531 located on the upper side of the optical chip 511 is mounted on the interposer substrate 130 together with the optical chip 511. As a result, it is not necessary to dispose a frame member on the interposer substrate 130 in order to support the transparent member 531 on the upper side of the optical chip 511, and the assembly step can be made efficient. In addition, the dummy chip 152 can be used as a sealing material for sealing the optical chip 511, and the reliability of the optical chip 511 can be improved.

Note that the molding material 151 may be disposed on the interposer substrate 130 so as to surround the periphery of the dummy chip 152.

### <7. Seventh embodiment>

In the fifth embodiment described above, the semiconductor chip 421 is provided at the position where the molding material 151 is in contact, and the optical chip 411 whose top surface is higher than that of the dummy chip 152 is provided at the position surrounded by the dummy chip 152. In the seventh embodiment, the semiconductor chip 421 is provided at a position where the molding material 151 is in contact, and the optical chip 511 whose top surface is lower than that of the dummy chip 152 is provided at a position surrounded by the dummy chip 152.

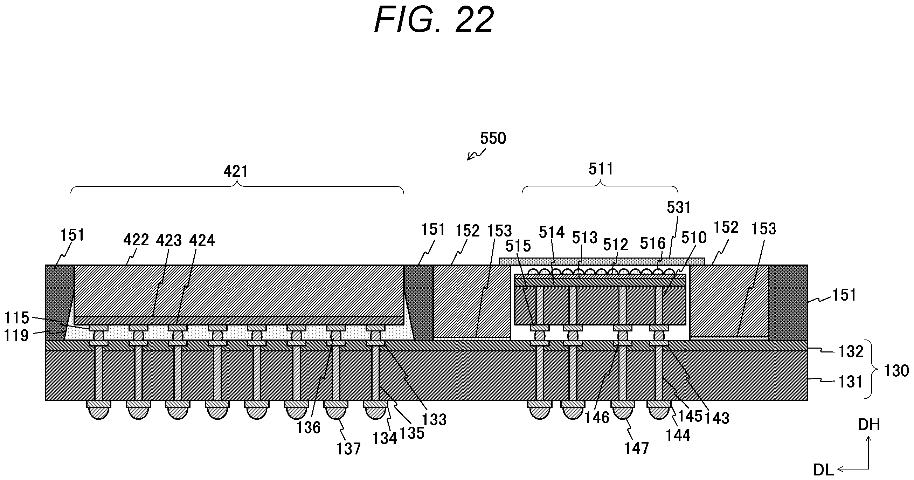

Fig. 22 is a cross-sectional view illustrating a configuration example of a package according to the seventh embodiment.

In the drawing, the package 550 includes the optical chip 511 and the transparent member 531 of the above-described sixth embodiment instead of the optical chip 411 of the package 400 of the fifth embodiment described above. Further, in the package 550, the antireflection film 431 of the fifth embodiment described above is omitted. Other configurations of the package 550 of the seventh embodiment are similar to those of the package 400 of the fifth embodiment described above.

The optical chip 511 and the semiconductor chip 421 are mounted on the interposer substrate 130.

The dummy chip 152 is disposed around the optical chip 511. The dummy chip 152 can be disposed on the interposer substrate 130 while being separated from the optical chip 511. At this time, the position of the top surface of the optical chip 511 in the height direction DH can be made lower than the position of the flat surface of the dummy chip 152 in the height direction DH. In the example in Fig. 22, the top surface of the optical chip 511 is the top surface of the on-chip lens 516. At this time, the flat surface of the dummy chip 152 can protrude in the height direction DH from the top surface of the optical chip 511.

On the interposer substrate 130, the molding material 151 is disposed so as to surround each of the semiconductor chip 421 and the dummy chip 152. At this time, the molding material 151 can contact the side surface of the semiconductor chip 421, the side surface of the underfill 119, and the outer peripheral surface of the dummy chip 152.

A transparent member 531 is provided on the upper side of the optical chip 511. The transparent member 531 is supported by the dummy chip 152 at a position separated from the optical chip 511. At this time, the end portion may be supported by the transparent member 531 at the position of the shoulder of the dummy chip 152.

As described above, in the above-described seventh embodiment, the semiconductor chip 421 surrounded by the molding material 151 is mounted on the interposer substrate 130, and the optical chip 511 whose top surface is lower than that of the dummy chip 152 is retrofitted. As a result, after the semiconductor chip 421 is mounted on the interposer substrate 130, the optical chip 511 can be mounted on the interposer substrate 130, and thermal damage or the like to the optical chip 511 due to the mounting of the semiconductor chip 421 can be suppressed.

In addition, the position of the top surface of the optical chip 511 in the height direction DH is set lower than the position of the flat surface of the dummy chip 152 in the height direction DH, and the transparent member 531 supported by the dummy chip 152 is disposed on an upper side of the optical chip 511. As a result, the sealing property of the optical chip 511 can be improved or the optical characteristics can be improved without increasing the planar size of the package 550.

### <8. Eighth embodiment>

In the fifth embodiment described above, the semiconductor chip 421 disposed at the position where the molding material 151 is in contact and the optical chip 411 disposed at the position surrounded by the dummy chip 152 are mounted on the interposer substrate 130. In an eighth embodiment, in order to facilitate filling of the underfill around the optical chip 411 disposed at the position surrounded by the dummy chip, a region in which the interval between the dummy chip and the optical chip 411 is enlarged is provided.

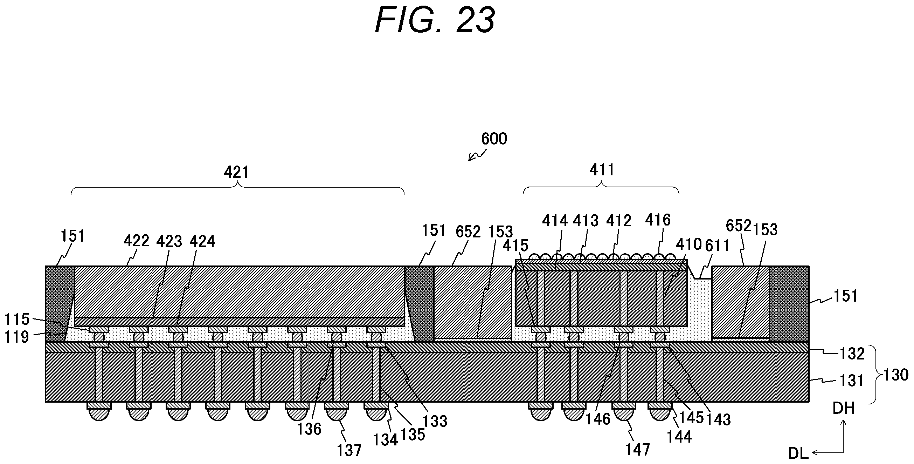

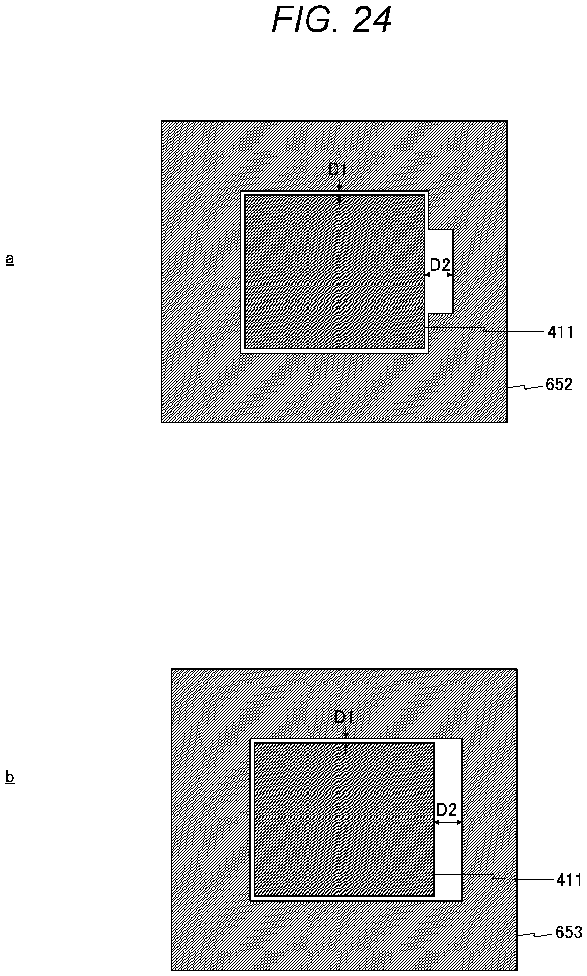

Fig. 23 is a cross-sectional view illustrating a configuration example of a package according to the eighth embodiment, and Fig. 24 is a plan view illustrating a configuration example of a dummy chip of the package according to the eighth embodiment. Note that a in Fig. 24 illustrates a first configuration example of the dummy chip of the eighth embodiment, and b in Fig. 24 illustrates a second configuration example of the dummy chip of the eighth embodiment.

In a in Figs. 23 and 24, an underfill 611 is added to the package 600 of the fifth embodiment described above in the package 400. Further, the package 600 is provided with a dummy chip 652 instead of the dummy chip 152 of the fifth embodiment described above. Other configurations of the package 600 of the eighth embodiment are similar to those of the package 400 of the fifth embodiment described above. Note that, in the package 600 of the eighth embodiment, the antireflection film 431 of the fifth embodiment described above is omitted, but the antireflection film 431 may or may not be provided.

An interval D2 of a part including an upper end of one surface facing the optical chip 411 among the surfaces of the dummy chip 652 is larger than an interval D1 of the other surface facing the optical chip 411. In order to form such an interval D2 on the surface of the dummy chip 652, a concave portion reaching the upper end of the surface may be formed on the surface.

The underfill 611 is provided between the interposer substrate 130 and the optical chip 411 and between the optical chip 411 and the dummy chip 652. The material of the underfill 611 is, for example, a thermosetting resin such as an epoxy resin. The underfill 611 can be injected from a position where an interval between the optical chip 411 and the dummy chip 652 is D2.

As described above, in the above-described eighth embodiment, the interval D2 of a part including the upper end of one surface facing the optical chip 411 among the surfaces of the dummy chip 652 is made larger than the interval D1 of the other surface facing the optical chip 411. As a result, the underfill 611 can be easily filled around the optical chip 411 disposed at the position surrounded by the dummy chip 652, and the reliability of the connection between the optical chip 411 and the interposer substrate 130 can be improved.

Note that a dummy chip 653 in b in Fig. 24 may be used instead of the dummy chip 652 in a in Fig. 24. Among the surfaces of the dummy chip 653, the interval D2 of the entire surface facing the optical chip 411 is larger than the interval D1 of the other surface facing the optical chip 411.

### <9. Ninth embodiment>

In the eighth embodiment described above, in order to facilitate filling of the underfill 611 around the optical chip 411 disposed at the position surrounded by the dummy chip 152, the region in which the interval between the dummy chip 152 and the optical chip 411 is enlarged is provided. In the ninth embodiment, in order to facilitate filling of the underfill 611 around the optical chip 411 disposed at the position surrounded by the dummy chip, a forward tapered shape is provided on a surface facing the optical chip 411 among surfaces of the dummy chip.

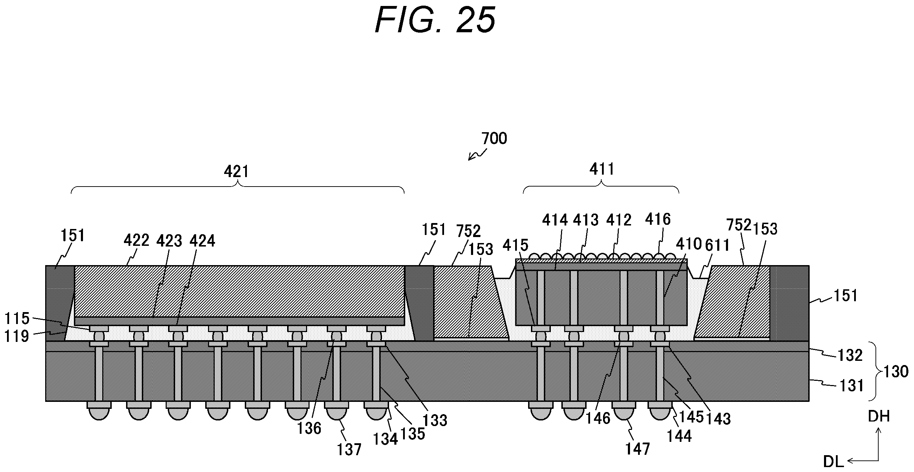

Fig. 25 is a cross-sectional view illustrating a configuration example of a package according to the ninth embodiment;

In the drawing, a package 700 is provided with a dummy chip 752 instead of the dummy chip 652 of the eighth embodiment described above. Other configurations of the package 700 of the ninth embodiment are similar to those of the package 600 of the eighth embodiment described above.

A forward tapered shape is provided on a surface facing the optical chip 411 among surfaces of the dummy chip 752. Such a dummy chip 752 can be easily realized by processing the groove 155 into a forward tapered shape when the groove 155 is formed in the dummy substrate 154 in Fig. 4. The underfill 611 is provided between the interposer substrate 130 and the optical chip 411 and between the optical chip 411 and the dummy chip 752.

As described above, in the above-described ninth embodiment, the forward tapered shape is provided on the surface facing the optical chip 411 among the surfaces of the dummy chip 752. As a result, the underfill 611 can be easily filled around the optical chip 411 disposed at the position surrounded by the dummy chip 752, and the reliability of the connection between the optical chip 411 and the interposer substrate 130 can be improved.

Note that, in the ninth embodiment described above, an example has been described in which the forward tapered shape is provided on the plurality of surfaces facing the optical chip 411 among the surfaces of the dummy chip 752. However, the forward tapered shape may be provided only on one surface facing the optical chip 411 among the surfaces of the dummy chip 752.

### <10. Tenth embodiment>

In the fifth embodiment described above, the semiconductor chip 421 disposed at the position where the molding material 151 is in contact and the optical chip 411 disposed at the position surrounded by the dummy chip 152 are mounted on the interposer substrate 130. In the tenth embodiment, the optical chip 411 is mounted on the semiconductor chip mounted on the interposer substrate 130.

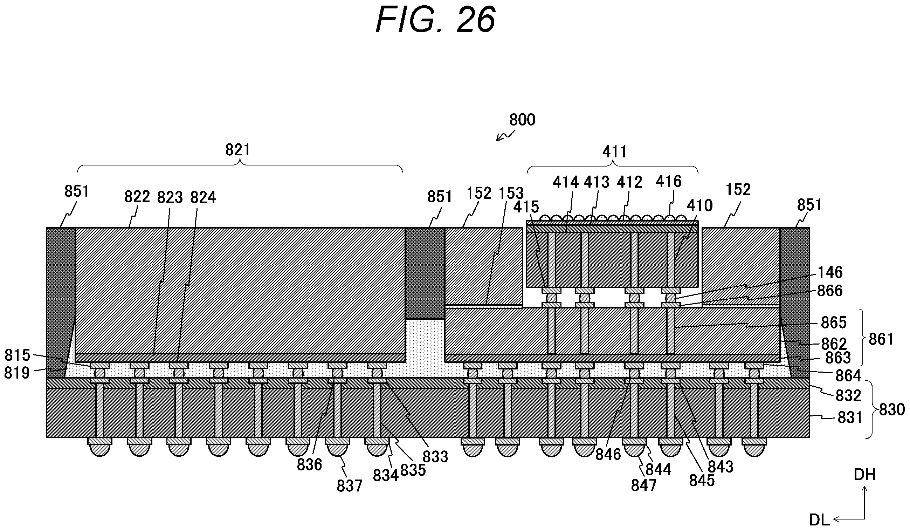

Fig. 26 is a cross-sectional view illustrating a configuration example of a package according to the tenth embodiment.

In the drawing, a package 800 includes the optical chip 411, semiconductor chips 821 and 861, and the dummy chip 152. The semiconductor chips 821 and 861 are mounted on an interposer substrate 830. The optical chip 411 is mounted on the semiconductor chip 861. The dummy chip 152 is mounted on the semiconductor chip 861 so as to surround the periphery of the optical chip 411. The dummy chip 152 can be disposed on the semiconductor chip 861 while being separated from the optical chip 411. Note that the semiconductor chip 861 is an example of a lower layer chip described in the claims.

A semiconductor element is formed on the semiconductor chip 821. For example, a signal processing circuit, a memory, an optical element, or the like may be formed on the semiconductor chip 821. Instead of the semiconductor chip 821, an optical chip may be mounted on the interposer substrate 130. At this time, as described in the second embodiment described above, a transparent resin and a transparent substrate may be included in the optical chip. The semiconductor chip 821 includes a semiconductor substrate 822 and a wiring layer 823. The wiring layer 823 is formed on the semiconductor substrate 822. A wiring buried in the insulating layer is provided on the wiring layer 823. Further, land electrodes 815 to which bump electrodes 836 are connected can be formed on the wiring layer 823.

A semiconductor element is formed on the semiconductor chip 861. For example, a signal processing circuit, a memory, an optical element, or the like may be formed on the semiconductor chip 861. The semiconductor chip 861 includes a semiconductor substrate 862 and a wiring layer 863. The wiring layer 863 is formed on the semiconductor substrate 862. A wiring buried in the insulating layer is provided on the wiring layer 863. Further, land electrodes 864 to which bump electrodes 846 are connected can be formed on the wiring layer 863.

Further, through electrodes 865 are formed on the semiconductor substrate 862. The through electrodes 865 are connected to the wiring layer 863. Further, land electrodes 866 connected to the through electrodes 865 are formed on the back surface side of the semiconductor substrate 862. The land electrode 866 is electrically connected to the land electrode 415 via the bump electrode 146.

The interposer substrate 830 includes a support substrate 831 and a wiring layer 832. Land electrodes 833 and 843 are formed on the wiring layer 832. A wiring (not illustrated) may be formed on the wiring layer 832. Land electrodes 834 and 844 are formed on the back surface of the support substrate 831. Further, through electrodes 835 and 845 are formed on the support substrate 831 and the wiring layer 832. Further, the land electrodes 833 and 834 are electrically connected to each other via the through electrode 835. The land electrodes 843 and 844 are electrically connected to each other via the through electrode 845. A bump electrode 837 is formed on the land electrode 834, and a bump electrode 847 is formed on the land electrode 844. The land electrode 815 is connected to the land electrode 833 via the bump electrode 836. The land electrode 864 is connected to the land electrode 844 via the bump electrode 846.

In addition, an underfill 819 is provided between the interposer substrate 830 and each of the semiconductor chips 821 and 861 and around each of the semiconductor chips 821 and 861. The material of the underfill 819 is, for example, a thermosetting resin such as an epoxy resin.

Further, on the interposer substrate 830, a molding material 851 is disposed so as to surround the periphery of each of the semiconductor chip 821 and the dummy chip 152. At this time, the molding material 851 can contact the side surface of the semiconductor chip 821, the side surface of the dummy chip 152, and the side surface of the underfill 819. Further, the position of the end portion of the molding material 851 in the lateral direction DL and the position of the end portion of the interposer substrate 830 in the lateral direction DL can coincide with each other.

The surface of the molding material 851 is flattened at a position surrounding the periphery of the semiconductor chip 821. The flat surface of the molding material 851 may be a polished surface. The position of the flat surface of the molding material 851 in the height direction DH can be made substantially equal to the position of the top surface of the semiconductor chip 821 in the height direction DH. Further, the position of the flat surface of the dummy chip 152 in the height direction DH can be made substantially equal to the position of the flat surface of the molding material 851 in the height direction DH.

As described above, in the above-described tenth embodiment, the optical chip 411 is mounted on the semiconductor chip 861 mounted on the interposer substrate 830. As a result, it is possible to threedimensionally integrate the divided chips without increasing the mounting area of the interposer substrate 830.

In addition, by forming the through electrodes 865 on the semiconductor chip 861 on which the optical chip 411 is mounted, it is possible to electrically connect the wiring layer 413 of the optical chip 411 to the outside while suppressing an increase in the wiring length. Therefore, it is possible to exchange the electrical signal with the optical chip 411 while suppressing an increase in delay of the electrical signal exchanged with the optical chip 411.

Note that, in the tenth embodiment, an example in which two chips are stacked as a three-dimensional integrated structure has been described, but three or more chips may be stacked. At this time, each chip is electrically connected via a through electrode, and the optical chip can be disposed on the uppermost layer.

### <11. Example of application to mobile object>

The technology according to the present disclosure (the present technology) can be applied to various products. For example, the technology according to the present disclosure may be achieved in the form of a device to be mounted on a mobile object of any kind, such as an automobile, an electric vehicle, a hybrid electric vehicle, a motorcycle, a bicycle, a personal mobility, an airplane, a drone, a vessel, or a robot.

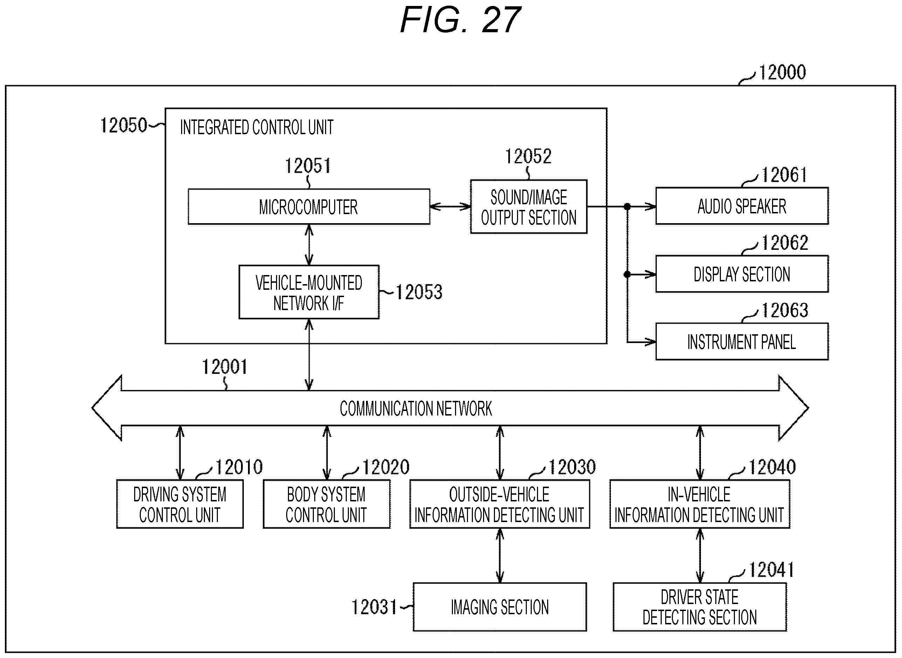

Fig. 27 is a block diagram illustrating a schematic configuration example of a vehicle control system as an example of a mobile object control system to which the technology according to the present disclosure is applied.

The vehicle control system 12000 includes a plurality of electronic control units connected to each other via a communication network 12001. In the example illustrated in Fig. 27, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example in Fig. 27, an audio speaker 12061, a display section 12062, and an instrument panel 12063 are illustrated as the output device. The display section 12062 may, for example, include at least one of an on-board display and a head-up display.

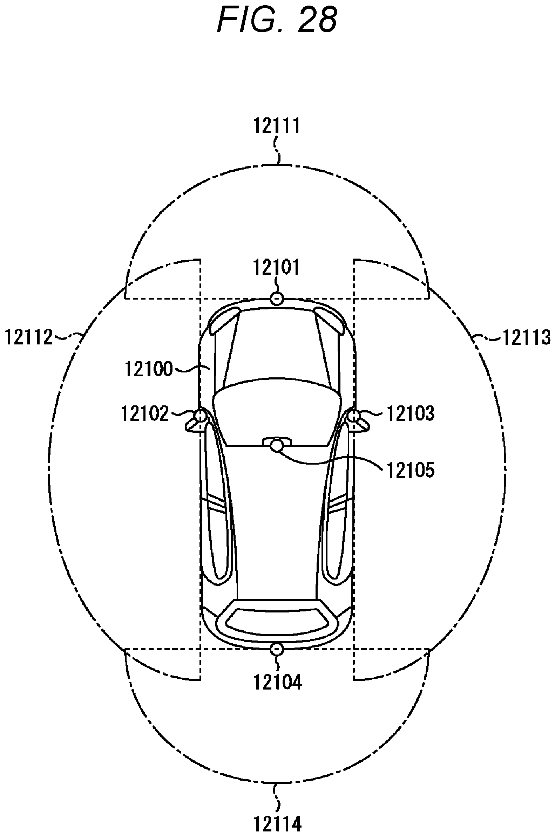

Fig. 28 is a diagram illustrating an example of an installation position of the imaging section 12031.

In Fig. 28, the imaging section 12031 includes imaging sections 12101, 12102, 12103, 12104, and 12105.

The imaging sections 12101,12102,12103,12104, and 12105 are provided, for example, at positions such as a front nose, a side mirror, a rear bumper, a back door, and an upper portion of a windshield in a vehicle interior of the vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 28 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can not only be applied to the imaging section 12031 and the driver state detecting section 12041 in the above-described configuration, but can also realize at least some functions of the electronic control unit. Specifically, for example, the package 100 in Fig. 1 can realize at least some functions of the electronic control unit while being applied to the imaging section 12031. By applying the technology according to the present disclosure to the vehicle control system 12000, it is possible to obtain a captured image while suppressing an increase in the mounting area, and to realize at least some functions of vehicle control.

Note that the embodiments described above illustrate an example for embodying the present technology, and the matters in the embodiments and the matters specifying the invention in the claims have a correspondence relationship. Similarly, the matters specifying the invention in the claims and matters with the same names in the embodiments of the present technology have correspondence relationships. However, the present technology is not limited to the embodiments, and can be embodied by applying various modifications to the embodiments without departing from the gist of the present technology. In addition, effects described in the present specification are merely examples and are not limited, and other effects may be provided.

Note that the present technology may also have the following configurations.
(1) A package including:
   a plurality of chips including an optical chip;
   a wiring layer on which the plurality of chips is mounted; and
   a molding material disposed so as to surround a periphery of at least one chip of the plurality of chips, the molding material having a flattened surface.
(2) The package according to (1), in which
   a position of the flat surface of the molding material in a height direction is substantially equal to a position of a top surface of at least one of the plurality of chips in the height direction.
(3) The package according to (1) or (2), in which
   the optical chip includes at least one of a light receiving element and a light emitting element.
(4) The package according to any one of (1) to (3), in which
   the wiring layer on which the plurality of chips is mounted is a wiring layer formed on an interposer substrate or a rewiring layer formed on the chip.
(5) The package according to any one of (1) to (4), further including an antireflection film formed on at least one of a chip other than the optical chip and the molding material.
(6) The package according to any one of (1) to (5), further including:
   a lower layer chip on which at least one of the plurality of chips is mounted; and
   a through electrode formed in the lower layer chip.
(7) The package according to any one of (1) to (6), further including a dummy chip that is disposed to be separated from a periphery of any one of the plurality of chips in a state where the periphery is surrounded by the molding material, and has a top surface located at substantially the same height as the flat surface of the molding material.
(8) The package according to any one of (1) to (7), further including
   a transparent member provided on an upper side of the optical chip,
   in which the molding material is located so as to surround a periphery of the optical chip in a state where a surface of the transparent member is exposed.
(9) The package according to (8), in which
   the transparent member includes at least one of a transparent resin and a transparent substrate.
(10) The package according to (9), in which
   the transparent member includes an optical functional layer.
(11) The package according to (7), in which
   a top surface of the optical chip is at a position lower than a top surface of the molding material.
(12) The package according to (11), further including a transparent substrate or an optical member disposed on an upper side of the optical chip and supported by the dummy chip.
(13) The package according to (7), in which
   a top surface of the optical chip is at a position higher than a top surface of the molding material.
(14) The package according to (13), further including an underfill provided between at least one of the plurality of chips and the wiring layer and around the chip.
(15) The package according to (14), in which
   at least a part including an upper end of one surface facing the chip among surfaces of the dummy chip has a larger interval from a chip surrounded by the dummy chip than other surfaces facing the chip.
(16) The package according to (14), in which
   at least one surface facing the chip among surfaces of the dummy chip has a forward tapered shape.
(17) A package including:
   an optical chip mounted on a substrate;
   a transparent member provided on the optical chip; and
   a sealing resin whose surface is flattened so that a surface of the transparent member is exposed and which is formed on the substrate so as to surround a periphery of the optical chip.
(18) The package according to (15), in which
   the flattened surface is a polished surface on which polishing is stopped at a position of the transparent member.
(19) A package including:
   a first chip on which a first wiring layer is formed;
   an extended rewiring layer electrically connected to the first wiring layer and extended in a lateral direction from a mounting region of the first chip; and
   a second chip which is mounted on the extended rewiring layer while being separated from the first chip and on which a second wiring layer electrically connected to the extended rewiring layer is formed.
(20) The package according to (17), further including a molding material formed on the extended rewiring layer so as to surround a periphery of at least one chip of the first chip and the second chip, the molding material having a flattened surface.
(21) The package according to (17) or (18), further including a dummy chip that is disposed on the extended rewiring layer while being separated from a periphery of at least one chip of the first chip and the second chip in a state where a periphery is surrounded by the molding material, and has a top surface located at substantially the same height as a surface of the molding material.
(22) A package including:
   an optical chip mounted on a substrate;
   a dummy chip that is disposed on the substrate while being separated from a periphery of the optical chip and protrudes from a top surface of the optical chip; and
   a transparent member disposed on an upper side of the optical chip and supported by the dummy chip.
(23) The package according to (20), further including a molding material formed on the substrate so as to surround a periphery of the dummy chip and having a flattened surface.
(24) A method for manufacturing a package, the method including:
   a step of sealing an optical chip provided with a transparent member on an upper side together with a dummy substrate with a molding material;
   a step of flattening a surface of the molding material to expose surfaces of the transparent member and the dummy substrate;
   a step of removing at least a part of the dummy substrate whose surface is exposed; and
   a step of mounting a chip in a region from which the dummy substrate has been removed.
(25) The method for manufacturing a package according to claim (22), in which
   flattening of the surface of the molding material is stopped at a position of the transparent member.
(26) A method for manufacturing a package, the method including:
   a step of sealing a chip and a dummy substrate with a molding material;
   a step of flattening a surface of the molding material to expose a surface of the dummy substrate;
   a step of removing at least a part of the dummy substrate whose surface is exposed; and
   a step of mounting an optical chip on a region from which the dummy substrate has been removed.

### REFERENCE SIGNS LIST

- 100 to 800: Package
- 111: Optical chip
- 121: Semiconductor chip
- 130: Interposer substrate
- 112: Semiconductor layer
- 113, 123, 132: Wiring layer
- 114, 131: Support substrate
- 115, 124, 133, 134, 143, 144: Land electrode
- 116: On-chip lens
- 117: Transparent resin
- 118: Transparent substrate
- 122: Semiconductor substrate
- 135, 145: Through electrode
- 136, 137: Bump electrode
- 151: Molding material
- 152: Dummy chip
- 153: Adhesive

## Claims

1. A package comprising:
a plurality of chips including an optical chip;
a wiring layer on which the plurality of chips is mounted; and
a molding material disposed so as to surround a periphery of at least one chip of the plurality of chips, the molding material having a flattened surface.

2. The package according to claim 1, wherein
a position of the flat surface of the molding material in a height direction is substantially equal to a position of a top surface of at least one of the plurality of chips in the height direction.

3. The package according to claim 1, wherein
the optical chip includes at least one of a light receiving element and a light emitting element.

4. The package according to claim 1, wherein
the wiring layer on which the plurality of chips is mounted is a wiring layer formed on an interposer substrate or a rewiring layer formed on the chip.

5. The package according to claim 1, further comprising an antireflection film formed on at least one of a chip other than the optical chip and the molding material.

6. The package according to claim 1, further comprising:
a lower layer chip on which at least one of the plurality of chips is mounted; and
a through electrode formed in the lower layer chip.

7. The package according to claim 1, further comprising a dummy chip that is disposed to be separated from a periphery of any one of the plurality of chips in a state where the periphery is surrounded by the molding material, and has a top surface located at substantially the same height as the flat surface of the molding material.

8. The package according to claim 1, further comprising
a transparent member provided on an upper side of the optical chip,
wherein the molding material is located so as to surround a periphery of the optical chip in a state where a surface of the transparent member is exposed.

9. The package according to claim 8, wherein
the transparent member includes at least one of a transparent resin and a transparent substrate.

10. The package according to claim 9, wherein
the transparent member includes an optical functional layer.

11. The package according to claim 7, wherein
a top surface of the optical chip is at a position lower than a top surface of the molding material.

12. The package according to claim 11, further comprising a transparent substrate or an optical member disposed on an upper side of the optical chip and supported by the dummy chip.

13. The package according to claim 7, wherein
a top surface of the optical chip is at a position higher than a top surface of the molding material.

14. The package according to claim 13, further comprising an underfill provided between at least one of the plurality of chips and the wiring layer and around the chip.

15. The package according to claim 14, wherein
at least a part including an upper end of one surface facing the chip among surfaces of the dummy chip has a larger interval from a chip surrounded by the dummy chip than other surfaces facing the chip.

16. The package according to claim 14, wherein
at least one surface facing the chip among surfaces of the dummy chip has a forward tapered shape.

17. A package comprising:
an optical chip mounted on a substrate;
a transparent member provided on the optical chip; and
a sealing resin whose surface is flattened so that a surface of the transparent member is exposed and which is formed on the substrate so as to surround a periphery of the optical chip.

18. The package according to claim 16, wherein
the flattened surface is a polished surface on which polishing is stopped at a position of the transparent member.

19. A package comprising:
a first chip on which a first wiring layer is formed;
an extended rewiring layer electrically connected to the first wiring layer and extended in a lateral direction from a mounting region of the first chip; and
a second chip which is mounted on the extended rewiring layer while being separated from the first chip and on which a second wiring layer electrically connected to the extended rewiring layer is formed.

20. The package according to claim 19, further comprising a molding material formed on the extended rewiring layer so as to surround a periphery of at least one chip of the first chip and the second chip, the molding material having a flattened surface.

21. The package according to claim 19, further comprising a dummy chip that is disposed on the extended rewiring layer while being separated from a periphery of at least one chip of the first chip and the second chip in a state where a periphery is surrounded by the molding material, and has a top surface located at substantially the same height as a surface of the molding material.

22. A package comprising:
an optical chip mounted on a substrate;
a dummy chip that is disposed on the substrate while being separated from a periphery of the optical chip and protrudes from a top surface of the optical chip; and
a transparent member disposed on an upper side of the optical chip and supported by the dummy chip.

23. The package according to claim 22, further comprising a molding material formed on the substrate so as to surround a periphery of the dummy chip and having a flattened surface.

24. A method for manufacturing a package, the method comprising:
a step of sealing an optical chip provided with a transparent member on an upper side together with a dummy substrate with a molding material;
a step of flattening a surface of the molding material to expose surfaces of the transparent member and the dummy substrate;
a step of removing at least a part of the dummy substrate whose surface is exposed; and
a step of mounting a chip in a region from which the dummy substrate has been removed.

25. The method for manufacturing a package according to claim 24, wherein
flattening of the surface of the molding material is stopped at a position of the transparent member.

26. A method for manufacturing a package, the method comprising:
a step of sealing a chip and a dummy substrate with a molding material;
a step of flattening a surface of the molding material to expose a surface of the dummy substrate;
a step of removing at least a part of the dummy substrate whose surface is exposed; and
a step of mounting an optical chip on a region from which the dummy substrate has been removed.
